# EUROPEAN PATENT APPLICATION

(11) **EP 4 535 339 A1**
(43) Date of publication of application: **09.04.2025**
(21) Application number: 23839770.7
(22) Date of filing: 10.05.2023
(51) Int. Cl.: G09F 9/30, H04M 1/02, H10K 50/84, G06F 1/16, H10K 102/00

(54) **ELECTRONIC DEVICE INCLUDING FLEXIBLE DISPLAY**

(30) Priority: 11.07.2022 KR 20220085036; 02.09.2022 KR 20220111133
(71) Applicant: Samsung Electronics Co., Ltd., Suwon-si, Gyeonggi-do 16677 (KR)
(72) Inventor: JUNG, Bowon, Suwon-si, Gyeonggi-do 16677 (KR); PARK, Soonik, Suwon-si, Gyeonggi-do 16677 (KR); YOON, Chungki, Suwon-si, Gyeonggi-do 16677 (KR); AN, Jungchul, Suwon-si, Gyeonggi-do 16677 (KR); KIM, Kwangtai, Suwon-si, Gyeonggi-do 16677 (KR); YEOM, Donghyun, Suwon-si, Gyeonggi-do 16677 (KR)
(74) Representative: Gulde & Partner
(86) International application number: PCT/KR2023/006349
(87) International publication number: WO 2024/014676

(57) **Abstract**

According to various embodiments, an electronic device may comprise: a first housing; a second housing coupled to the first housing to be foldable with respect to a folding axis via a hinge device; and a flexible display disposed to be supported by the first housing and the second housing and including a folding area, wherein the flexible display includes a window layer, a display panel disposed under the window layer, a support plate disposed under the display panel and including a pattern formed at a position at least corresponding to the folding area, and at least one functional layer disposed under the support plate; and includes a first adhesive member disposed between the first housing and at least one functional layer to have a length in the direction parallel to the folding axis in a position adjacent at least to one side of the folding area and a second adhesive member disposed between the second housing and at least one functional layer to have a length in the direction parallel to the folding axis in a position adjacent at least to the other side of the folding area.

## Description

### [Technical Field]

Embodiments of the disclosure relate to an electronic device including a flexible display.

### [Background Art]

Electronic devices are being gradually slimmed and are being improved to increase rigidity of the electronic devices, to enhance design aspects, and to differentiate functional elements thereof. Electronic devices are gradually evolving from a uniform rectangular shape to diverse shapes. An electronic device may have a transformable structure that is convenient to carry and enables the use of a large-screen display. For example, as part of the transformable structure, an electronic device may include foldable housings that operate by folding or unfolding relative to one another. Such an electronic device may require a support structure that can reduce deformation of the flexible display caused by frequent folding operations.

### [Disclosure of Invention]

### [Technical Problem]

A foldable electronic device may include a hinge device (e.g., a hinge structure or hinge module), and a first housing and a second housing that are connected via the hinge device to be foldable relative to each other in opposite directions. This foldable electronic device may operate in an in-folding and/or out-folding manner, allowing the first housing to rotate relative to the second housing within a range of 0 to 360 degrees via the hinge module. The foldable electronic device may include a flexible display disposed to be at least partially supported by the first and second housings in the unfolded state. This flexible display may include multiple layers (e.g., window layer, POL, polymer layer, or at least one functional layer) disposed on the top surface and/or the bottom surface relative to the display panel.

The flexible display may include a folding area formed at the boundary between the first and second housings due to the folding operation. The folding area may undergo deformation as the electronic device is folded and unfolded. A flexible display may include visually identifiable crease areas formed longitudinally along the folding axis on the folding area and the left and right of the folding area, due to frequent folding and unfolding operations. For example, in the unfolded state, the folding area may sag downward lower than the surface of the display (the surface of the display formed flat in the unfolded state), while the crease areas on the left and right of the folding area may protrude upward, higher than the display surface, due to the sagging of the folding area.

The surface quality of the flexible display may deteriorate due to the protrusion or sagging of the folding area and the crease areas relative to the display surface, and the reliability of the electronic device may decrease as this becomes visible to the user.

Various embodiments of the disclosure may provide an electronic device including a flexible display with a laminated structure that may help improve surface quality.

Various other embodiments may provide an electronic device including a flexible display that may help improve durability.

However, the problems that the disclosure seeks to solve are not limited to the aforementioned problems, and may be expanded in various ways without departing from the spirit and scope of the disclosure.

### [Solution to Problem]

According to various embodiments, an electronic device may include a first housing, a second housing coupled to the first housing to be foldable around a folding axis via a hinge device, and a flexible display disposed to be supported by the first housing and the second housing and including a folding area. The flexible display may include a window layer, a display panel disposed under the window layer, a support plate disposed under the display panel and including a pattern formed at least at a position corresponding to the folding area, and at least one functional layer disposed under the support plate. The electronic device may include a first adhesive member disposed between the first housing and the at least one functional layer at a position adjacent to one side of the folding area to have a length in a direction parallel to the folding axis, and a second adhesive member disposed between the second housing and the at least one functional layer at a position adjacent to the other side of the folding area to have a length in a direction parallel to the folding axis.

An electronic device may include a first housing, a second housing coupled to the first housing to be foldable around a folding axis via a hinge device, a flexible display disposed to be supported by the first housing and the second housing and including a folding area. The flexible display may include a window layer, a display panel disposed under the window layer, a support plate disposed under the display panel and including a pattern formed at least at a position corresponding to the folding area, and at least one functional layer disposed under the support plate. The electronic device may include a first cushion member disposed between the first housing and the at least one functional layer at a position overlapping at least the folding area when viewed from above the flexible display, and a second cushion member disposed between the second housing and the at least one functional layer at a position overlapping at least the folding area when viewed from above the flexible display.

### [Advantageous Effects of Invention]

An electronic device according to exemplary embodiments of the disclosure has a bonding structure that bonds housings to a flexible display through adhesive members disposed longitudinally along a folding axis at portions corresponding to crease areas formed on opposite sides of a folding area, thereby reducing upward protrusion relative to the surface of the display in the unfolded state and helping improve surface quality. In addition, at least in the portion corresponding to the folding area, a cushion member made of a high compression force deflection (CFD) material has a support structure that supports the folding area, thereby reducing downward sagging of the folding area relative to the display surface in the unfolded state and helping improve surface quality.

In addition, various other effects identified directly or indirectly through this document may be provided.

The effects that are capable of being obtained by the disclosure are not limited to those described above, and other effects not described above may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1A is a front perspective view illustrating an electronic device according to various embodiments of the disclosure in an unfolded or flat state.
FIG. 1B is a plan view illustrating the front surface of the electronic device according to various embodiments of the disclosure in the unfolded state.
FIG. 1C is a plan view illustrating the rear surface of the electronic device according to various embodiments of the disclosure in the unfolded state.
FIG. 2A is a perspective view illustrating the electronic device according to various embodiments of the disclosure in the folded state.
FIG. 2B is a perspective view illustrating the electronic device according to various embodiments of the disclosure in an intermediate state.
FIG. 3 is an exploded perspective view of the electronic device according to various embodiments of the disclosure.
FIG. 4 is an exploded perspective view of a flexible display according to various embodiments of the disclosure.
FIG. 5 is a partial cross-sectional view of the electronic device according to various embodiments of the disclosure taken along line 5-5 in FIG. 1A.
FIGS. 6A to 6H are plan views illustrating an electronic device with various arrangement structures of adhesive members according to various embodiments of the disclosure.
FIGS. 7A and 7B are front and rear views of an electronic device according to various embodiments of the disclosure in an unfolded state.
FIGS. 8A and 8B are front and rear views of the electronic device according to various embodiments of the disclosure in a folded state.
FIG. 9 is an exploded perspective view of an electronic device according to various embodiments of the disclosure.
FIG. 10 is a partial cross-sectional view of an electronic device viewed along line 10-10 of FIG. 7A, according to various embodiments of the disclosure.
FIGS. 11A to 11H are plan views illustrating an electronic device with various arrangement structures of adhesive members according to various embodiments of the disclosure.
FIG. 12 is a partial cross-sectional view of an electronic device including cushion members according to various embodiments of the disclosure.
FIGS. 13A and 13B are plan views illustrating an electronic device with various arrangement structures of cushion members according to various embodiments of the disclosure.
FIGS. 14A to 14C are partial cross-sectional views of an electronic device with adhesive members and cushion members according to various embodiments of the disclosure.
FIG. 15 is a partial cross-sectional view of an electronic device according to various embodiments of the disclosure.

### [Mode for the Invention]

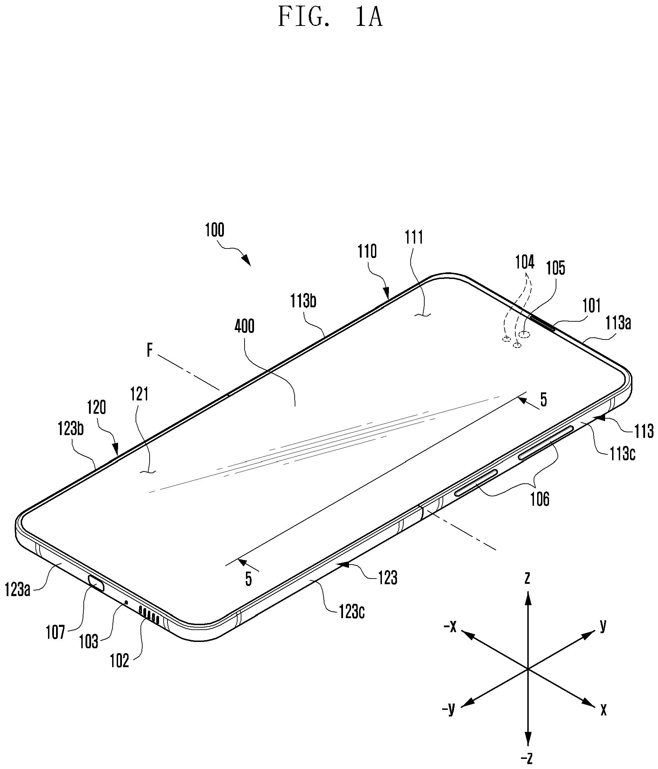

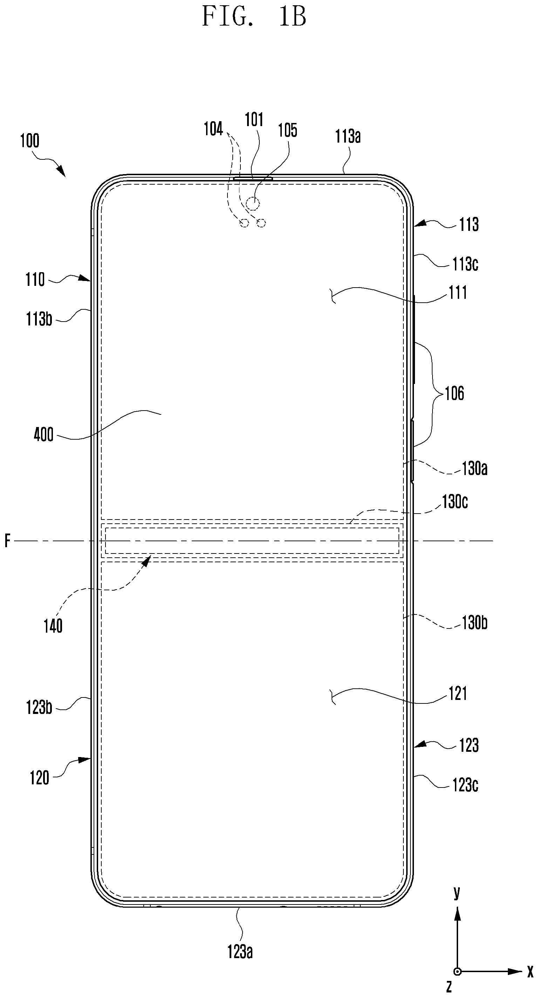

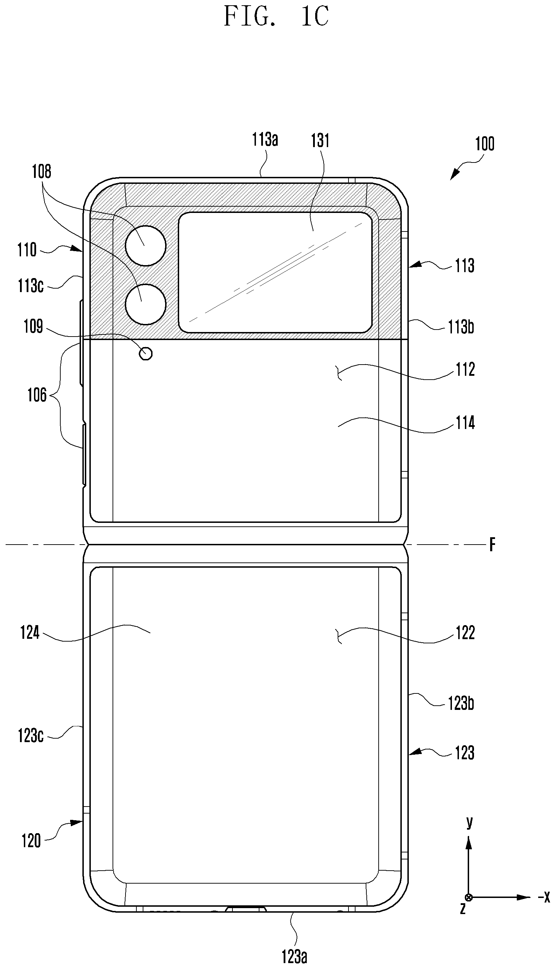

FIG. 1A is a perspective view of an electronic device illustrating a flat state or unfolded state of the electronic device according to an embodiment of the disclosure. FIG. 1B is a plan view illustrating a front surface of an electronic device in an unfolded state according to an embodiment of the disclosure. FIG. 1C is a plan view illustrating a rear surface of an electronic device in an unfolded state according to an embodiment of the disclosure.

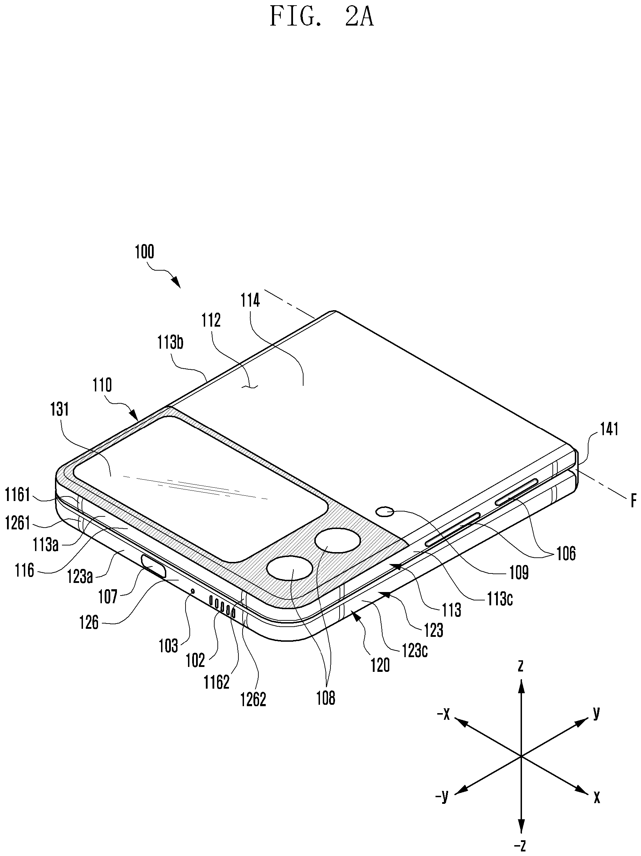

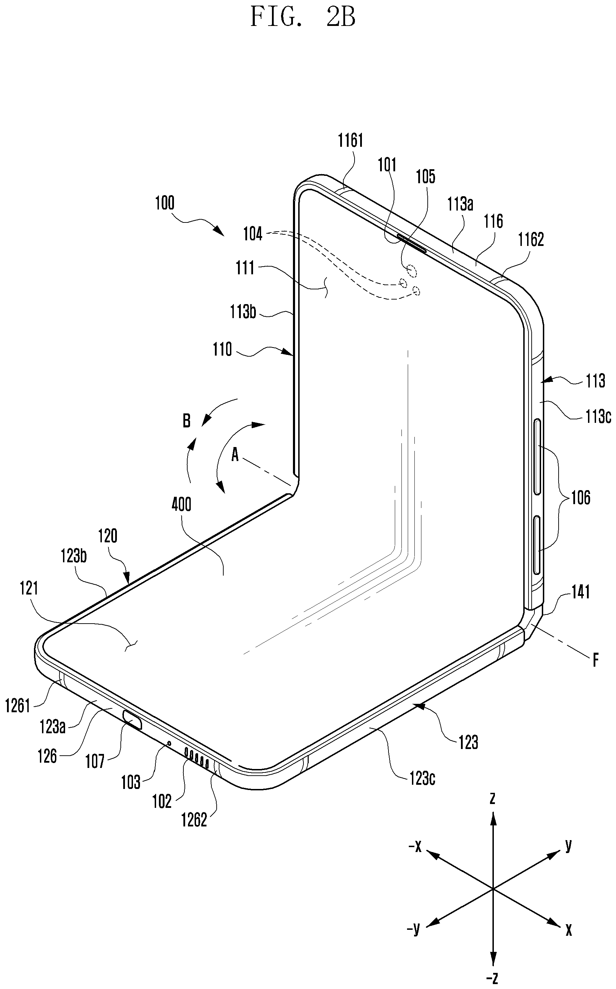

FIG. 2A is a perspective view of an electronic device illustrating a folded state of the electronic device according to an embodiment of the disclosure. FIG. 2B is a perspective view of an electronic device illustrating an intermediate state of the electronic device according to an embodiment of the disclosure.

Referring to FIGS. 1A to 1C, 2A, and 2B, an electronic device 100 may include first and second housings 110 and 120 (e.g., a foldable housing structure) that are connected so that they can be folded with respect to each other based on a hinge device (e.g., the hinge device 140 of FIG.1B). In one embodiment, the hinge device (e.g., the hinge device 140 of FIG. 1B) may be disposed in the direction of the X axis or in the direction of the Y axis. In one embodiment, the electronic device 100 may include a first display 130 (e.g., a flexible display, a foldable display, or a main display) disposed in an area (e.g., recess) formed by the first and second housings 110 and 120. In one embodiment, the first housing 110 and the second housing 120 may be disposed on opposite sides centered on the folding axis F and may have a shape that is substantially symmetrical with respect to the folding axis F. In one embodiment, the angle or distance between the first housing 110 and the second housing 120 may vary depending on the state of the electronic device 100. For example, depending on whether the electronic device is in a flat state or an unfolded state, a folded state, or an intermediate state, the first housing 110 and the second housing 120 may have different angles or distances formed from each other.

In one embodiment, the first housing 110 may include a first surface 111 facing the first direction (e.g., the front direction) (z axis direction) and a second surface 112 facing the second direction (i.e., the rear direction) (-z axis direction) opposite the first surface 111 in the unfolded state of the electronic device 100. In one embodiment, the second housing 120, in the unfolded state of electronic device 100, may include a third surface 121 facing the first direction (in the z-axis direction) and a fourth surface 122 facing the second direction (-z axis direction). In one embodiment, in the unfolded state of the electronic device 100, the first surface 111 of the first housing 110 and the third surface 121 of the second housing 120 may face substantially the same first direction (in the direction of the z axis). In one embodiment, in the folded state of the electronic device 100, the first surface 111 of the first housing 110 and the third surface 121 of the second housing 120 may face each other. In one embodiment, in the unfolded state of the electronic device 100, the second surface 112 of the first housing 110 and the fourth surface 122 of the second housing 120 may face substantially the same second direction (- z axis direction). In one embodiment, in the folded state of the electronic device 100, the second surface 112 of the first housing and the fourth surface 122 of the second housing 120 may face opposite each other. For example, in the folded state of electronic device 100, the second surface 112 may face the first direction (in the z axis), and the fourth surface 122 may face the second direction (-z axis direction). In this case, the first display 130 may not be visible from the outside (in folding mode). In one embodiment, the electronic device 100 may be folded so that the second surface 112 of the first housing 110 and the fourth surface 122 of the second housing 120 face each other. In this case, the first display 130 may be disposed to be viewed from the outside (out-folding).

According to various embodiments, the first housing 110 (e.g., the first housing structure) may include a first lateral member 113 that at least partially forms an exterior of the electronic device 100, and a first rear surface cover 114 (e.g., a first rear cover) that is coupled to the first lateral member 113 and forms at least portion of the second surface 112 of the electronic device 100. In one embodiment, the first lateral member 113 may include the first side surface 113a, the second side surface 113b extending from one end of the first side surface 113a, and the third side surface 113c extending from the other end of the first side surface 113a. In one embodiment, the first lateral member 113 may be formed into a quadrilateral (e.g., square or rectangular) shape through the first side surface 113a, the second side surface 113b, and the third side surface 113c.

According to various embodiments, the second housing 120 (e.g., the second housing structure) may include a second lateral member 123 that at least partially forms an exterior of the electronic device 100, and a second rear surface cover 124 (e.g., a second rear cover) that is at least partially coupled to the second lateral member 123, and a second lateral member 123 and forms at least portion of the fourth surface 122 of the electronic device 100. In one embodiment, the second lateral member 123 may include the fourth side surface 123a, a fifth side surface 123b extending from one end of the fourth side surface 123a, and the sixth side surface 123c extending from the other end of the fourth side surface 123a. In one embodiment, the second lateral member 123 may be formed into a quadrilateral shape through the fourth side surface 123a, the fifth side surface 123b, and the sixth side surface 123c.

According to various embodiments, the first and second housings 110, 120 are not limited to the illustrated shape and combination, and may be implemented by a combination and/or a coupling of other shapes or parts. In one embodiment, the first lateral member 113 may be integrally formed with the first rear surface cover 114, and the second lateral member 123 may be integrally formed with the second rear surface cover 124.

According to various embodiments, in the unfolded state of the electronic device 100, the second side surface 113b of the first lateral member 113 and the fifth side surface 123b of the second lateral member 123 may be connected without a gap. In one embodiment, in the unfolded state of the electronic device 100, the third side surface 113c of the first lateral member 113 and the sixth side surface 123c of the second lateral member 123 may be connected without a gap. In one embodiment, when electronic device 100 is unfolded, the sum of the lengths of the second side surface 113b and the fifth side surface 123b may be constituted to be longer than the length of the first side surface 113a and/or the fourth side surface 123a. In one embodiment, in the unfolded state of electronic device 100, the sum of the lengths of the third side surface 113c and the sixth side surface 123c may be constituted to be longer than the length of the first side surface 113a and/or the fourth side surface 123a.

Referring to FIGS. 2A and 2B, the first lateral member 113 and/or the second lateral member 123 may contain more polymers formed from or injected into metal. In one embodiment, the first lateral member 113 and/or the second lateral member 123 may also include at least one conductive portion 116 and/or 126 electrically segmented through at least one segmentation portion 1161, 1162 and/or 1261, 1262 formed by the polymer. In such a case, at least one conductive portion 116 and/or 126 may be used as at least portion of an antenna operating in at least one band (e.g., legacy band) specified by an electrical connection with a radio communication circuit contained in electronic device 100.

According to various embodiments, the first rear surface cover 114 and/or the second rear surface cover 124 may be formed by a combination of at least one or at least two of the coated or colored glass, ceramics, polymers, or metals (e.g., aluminum, stainless steel (STS), or magnesium).

According to various embodiments, the first display 130 may be disposed to extend from the first surface 111 of the first housing 110 across the hinge device (e.g., the hinge device 140 of FIG. 1B) to at least a portion of the third surface 121 of the second housing 120. In one embodiment, the first display 130 may substantially include a first area 130a corresponding to the first surface 111, a second area 130b corresponding to the second surface 112, and a third area 130c (e.g., a flexible area or folding area) connecting the first area 130a and the second area 130b.In one embodiment, the third area 130c may be disposed in a position corresponding to the hinge device (e.g., the hinge device 140 of FIG. 1B) as part of the first area 130a and/or the second area 130b. In one embodiment, the electronic device 100 may include a hinge housing 141 (e.g., a hinge cover) supporting a hinge device (e.g., the hinge device 140 of FIG. 1B). In one embodiment, the hinge housing 141 may be exposed to the outside when the electronic device 100 is in the folded state, and may be disposed invisibly from the outside by being inserted into the inner space of the first housing 110 and the inner space of the second housing 120when the electronic device 100 is in the unfolded state.

According to various embodiments, electronic device 100 may include a second display 131 (e.g., a subdisplay) that is disposed separately from the first display 130. In one embodiment, the second display 131 may be disposed on the second surface 112 of the first housing 110 to be at least partially exposed. In one embodiment, when the electronic device 100 is in a folded state, the second display 131 may display at least portion of the state information of the electronic device 100, replacing at least portion of the display function of the first display 130. In one embodiment, the second display 131 may be disposed so that it can be viewed from the outside through at least portion of the area of the first rear surface cover 114.In one embodiment, the second display 131 may be disposed on the fourth surface 122 of the second housing 120. In such a case, the second display 131 may be disposed so that it can be viewed from the outside through at least portion of the area of the second rear surface cover 124.

According to various embodiments, the electronic device 100 may include at least one of an input device 103 (e.g., microphone), a sound output device 101 and 102, a sensor module 104, a camera device 105 and 108, a keystroke device 106 or a connector port 107. In the illustrated embodiment, the input device 103 (e.g., microphone), the sound output device 101 and 102, the sensor module 104, the camera device 105 and 108, the keystroke device 106 or the connector port 107 are illustrated as holes or circular elements formed in the first housing 110 or second housing 120, but this is illustrative for the purpose of explanation and is not limited thereto. According to various embodiments, input device 103 may include at least one microphone 103 disposed in second housing 120. In one embodiment, input device 103 may include a plurality of microphones 103 that are disposed to detect the direction of sound. In one embodiment, a plurality of microphones 103 may be disposed in appropriate locations in the first housing 110 and/or the second housing 120. In one embodiment, sound output devices 101 and 102 may include at least one speaker 101 and 102. In one embodiment, at least one speaker 101 and 102 may include a call receiver 101 disposed in the first housing 110 and a speaker 102 disposed in the second housing 120. In one embodiment, input device 103, sound output device 101 and 102 and connector port 107 are disposed in a space provided in the first housing 110 and/or second housing 120 of the electronic device 100 and may be exposed to the external environment through at least one hole formed in the first housing 110 and/or second housing 120. In one embodiment, at least one connector port 107 may be used to transmit and receive power and/or data with an external electronic device. In one embodiment, at least one connector port (e.g., an earjack hole) may also accommodate a connector (e.g., an earjack) for transmitting and receiving audio signals with an external electronic device. In one embodiment, holes formed in first housings 110 and/or second housings 120 may be used for input devices 103 and sound output devices 101 and 102. In one embodiment, sound output devices 101 and 102 may also include speakers (e.g., piezo speakers) that are not exposed through holes formed in the first housing 110 and/or second housing 120.

According to various embodiments, the sensor module 104 may generate electrical signals or data values corresponding to the internal operating state of electronic device 100 or external environmental conditions. In one embodiment, the sensor module 104 may detect the external environment through the first surface 111 of the first housing 110. In one embodiment, the electronic device 100 may include at least one additional sensor module that is disposed to detect the external environment through the second surface 112 of the first housing 110. In one embodiment, sensor module 104 (e.g., an illuminance sensor) may be disposed under first display 130 to detect the external environment through first display 130.In one embodiment, the sensor module 104 may include at least one of the following gesture sensors, gyro sensors, barometric pressure sensors, magnetic sensors, acceleration sensors, grip sensors, color sensors, infrared (IR) sensors, biometric sensors, temperature sensors, humidity sensors, ambient light sensors, proximity sensors, biometric sensors, ultrasonic sensors, or ambient light sensors 104.

According to various embodiments, camera devices 105 and 108 may include a first camera device 105 (e.g., a front camera device) disposed on the first surface 111 of the first housing 110 and a second camera device 108 disposed on the second surface 112 of the first housing 110. In one embodiment, electronic device 100 may further include flash 109 disposed near second camera device 108. In one embodiment, camera devices 105 and 108 may include at least one lens, an image sensor, and/or an image signal processor. In one embodiment, camera devices 105 and 108 may be disposed so that two or more lenses (e.g., a wide-angle lens, an ultra-wide-angle lens, or a telephoto lens) and two or more image sensors are located on one surface of the electronic device 100 (e.g., the first surface 111, the second surface 112, the third surface 121), or the fourth surface 122).In one embodiment, the camera devices 105 and 108 may include lenses and/or image sensors for time of flight (TOF).

According to various embodiments, the keystroke device 106 (e.g., a key button) may be disposed on the third side surface 113c of the first lateral member 113 of the first housing 110. In one embodiment, the keystroke device 106 may be disposed on at least one side surface of the other side surfaces 113a and 113b and/or side surfaces 123a, 123b, and 123c of the second housing 120. In one embodiment, the electronic device 100 may not include some or all of the keystroke devices 106 and the non-contained keystroke device 106 may be implemented in another form, such as a soft key, on the first display 130. In one embodiment, the keystroke device 106 may be implemented using a pressure sensor included in first display 130.

According to various embodiments, some of the camera devices 105 and 108 (e.g., the first camera device 105) or sensor module 104 may be disposed to be exposed through the first display 130. In one embodiment, the first camera device 105 or sensor module 104 may be optically exposed to the outside through an opening (e.g., a through hole) formed at least partially on the first display 130 in the inner space of the electronic device 100. In one embodiment, at least portion of the sensor module 104 may be disposed in the inner space of the electronic device 100 so that it is not visually exposed through the first display 130.With reference to FIG. 2B, the electronic device 100 may be operated through a hinge device (e.g., the hinge device 140 of FIG. 1B) to maintain at least one specified folding angle in the intermediate state. In such a case, electronic device 100 may control the first display 130 so that different contents are displayed in the display area corresponding to the first surface 111 and the display area corresponding to the third surface 121.In one embodiment, the electronic device 100 may operate in a substantially unfolded state (e.g., the unfolded state of FIG. 1A) and/or in a substantially folded state (e.g., the folded state of FIG. 2A) with respect to a certain folding angle (e.g., the angle between the first housing 110 and the second housing 120when the electronic device 100 is in an intermediate state) through a hinge device (e.g., the hinge device 140 of FIG. 1B). In one embodiment, the electronic device 100 may be operated through a hinge device (e.g., the hinge device 140 of FIG. 1B) to transition to an unfolded state (e.g., the unfolded state of FIG. 1A) when pressurized force is provided in the unfolding direction (A direction) at a certain folding angle. In one embodiment, the electronic device 100 may be operated through a hinge device (e.g., the hinge device 140 of FIG. 1B) in an unfolded state at a certain folding angle, to transition to a folded state (e.g., a folding state of FIG. 2A) if pressing force is provided in the direction to be folded (B direction). In one embodiment, the electronic device 100 may be operated through a hinge device (e.g., the hinge device 140 of FIG. 1B) to maintain an unfolded state (not shown) at various folding angles (free-stop function).

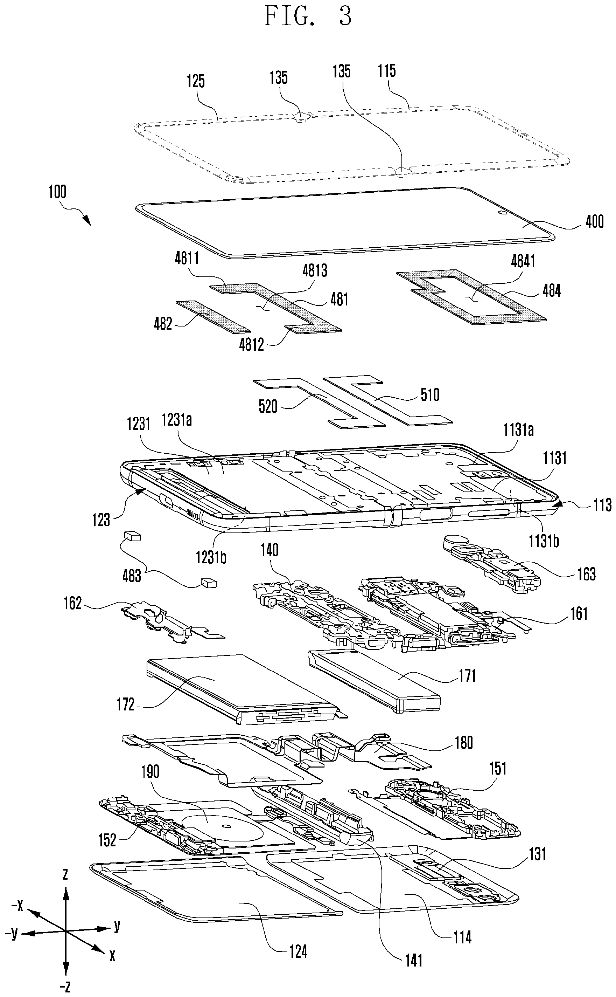

FIG. 3 is an exploded perspective view of an electronic device according to an embodiment of the disclosure.

Referring to FIG. 3, an electronic device 100 may include a first lateral member 113 (e.g., a first side surface frame), a second lateral member 123 (e.g., a second side surface frame), and a hinge assembly HA (e.g., the hinge assembly HA in FIG. 1B) (e.g., a hinge device, a hinge module, or a hinge structure) configured to connect the first lateral member 113 and the second lateral member 123 so that the first lateral member 113 and the second lateral member 123 are rotatable. In the embodiment, the electronic device 100 may include a first support member 1131 (e.g., a first support plate) at least partially extending from the first lateral member 113, and a second support member 1231 (e.g., a second support plate) at least partially extending from the second lateral member 123. In the embodiment, the first support member 1131 may be integrated with the first lateral member 113 or structurally coupled to the first lateral member 113. In the embodiment, the second support member 1231 may be integrated with the second lateral member 123 or structurally coupled to the second lateral member 123. In the embodiment, a first display 130 may be disposed to be supported by the first support member 1131 and the second support member 1231. In the embodiment, the electronic device 100 may include a first rear surface cover 114 coupled to the first lateral member 113 and configured to provide a first space between the first support member 1131 and the first rear surface cover 114, and a second rear surface cover 124 coupled to the second lateral member 123 and configured to provide a second space between the second support member 1231 and the second rear surface cover 124. In the embodiment, the first lateral member 113 and the first rear surface cover 114 may be integrated. In the embodiment, the second lateral member 123 and the second rear surface cover 124 may be integrated. In the embodiment, a first housing 110 may include the first lateral member 113, the first support member 1131, and the first rear surface cover 114. In the embodiment, a second housing 120 may include the second lateral member 123, the second support member 1231, and the second rear surface cover 124. In the embodiment, the electronic device 100 may include a second display 131 disposed to be visible from the outside through at least a partial area of the first rear surface cover 114.

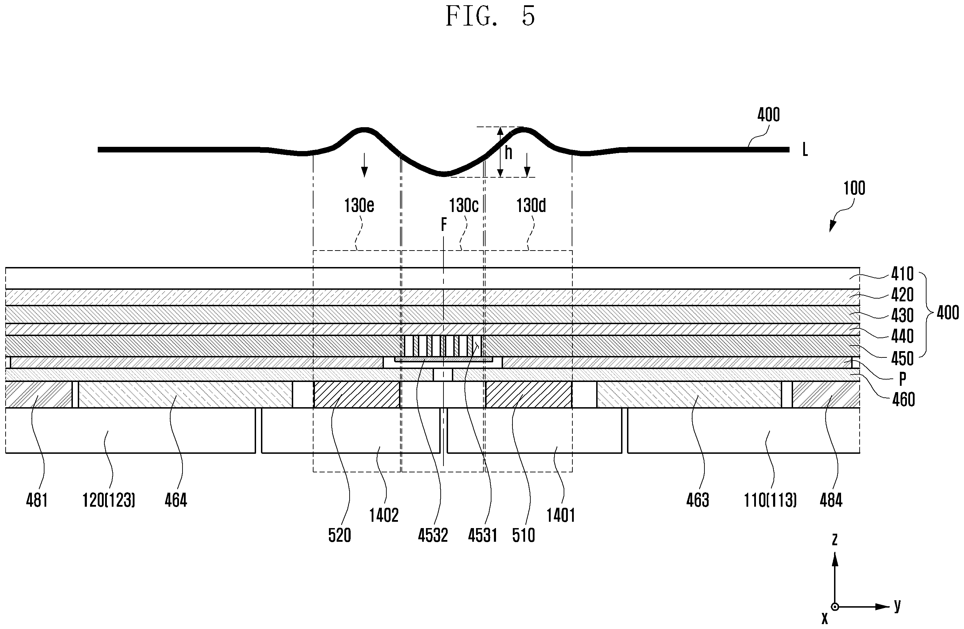

According to various embodiments, the electronic device 100 may include a first substrate 161 (e.g., a first substrate assembly or a main printed circuit board), a camera assembly 163, a first battery 171, or a first bracket 151 disposed in the first space between the first lateral member 113 and the first rear surface cover 114. In the embodiment, the camera assembly 163 may include a plurality of camera devices (e.g., the camera devices 105 and 108 in FIGS. 1A and 2A) and be electrically connected to the first substrate 161. In the embodiment, the first bracket 151 may provide a support structure for supporting the first substrate 161 and/or the camera assembly 163 and provide improved rigidity. In the embodiment, the electronic device 100 may include a second substrate 162 (e.g., a second substrate assembly or a sub-printed circuit board), an antenna 190 (e.g., a coil member), a second battery 172, or a second bracket 152 disposed in the second space between the second lateral member 123 and the second rear surface cover 124. In the embodiment, the electronic device 100 may include a wiring member 180 (e.g., a flexible substrate (flexible printed circuit board (FPCB)) configured to provide electrical connection and disposed to extend from the first substrate 161 to the plurality of electronic components (e.g., the second substrate 162, the second battery 172, or the antenna 190), which is disposed between the second lateral member 123 and the second rear surface cover 124, while traversing the hinge assembly HA (e.g., the hinge assembly HA in FIG. 5). In the embodiment, the antenna 190 may include a near-field communication (NFC) antenna, a wireless charging antenna, and/or a magnetic secure transmission (MST) antenna.

According to various embodiments, the electronic device 100 may include a first protective cover 115 (e.g., a first protective frame or a first decorative member) coupled along an edge of the first housing 110, and a second protective cover 125 (e.g., a second protective frame or a second decorative member) coupled along an edge of the second housing 120. In the embodiment, the first protective cover 115 and/or the second protective cover 125 may be made of metal or a polymer material. In the embodiment, the first protective cover 115 and/or the second protective cover 125 may be used as decorative members. In this case, the first display 130 may be disposed so that an edge of a first area (e.g., the first area 130a in FIG. 1B) is not visible from the outside between the first housing 110 and the first protective cover 115. In the embodiment, the first display 130 may be disposed so that an edge of a second area (e.g., the second area 130b in FIG. 1B) is not visible from the outside between the second housing 120 and the second protective cover 125.

According to various embodiments, the electronic device 100 may also include a protective structure 135 disposed to protect an edge of a third area (e.g., the third area 130c in FIG. 1B) of the first display 130. In this case, an edge of the first display 130 may be protected by the protective structure 135 disposed at a position corresponding to a folding area (e.g., the folding area 130c in FIG. 1B).

According to various embodiments, the first support member 1131 may include a first support surface 1131a directed in a first direction (z-axis direction), and a second support surface 1131b directed in a second direction (-z-axis direction) opposite to the first direction. In the embodiment, the second support member 1231 may include a third support surface 1231a directed in the first direction (z-axis direction) in the unfolded state of the electronic device 100, and a fourth support surface 1231b directed in the second direction (-z-axis direction). In the embodiment, the first display 130 may be disposed to be supported by the first support surface 1131a of the first support member 1131 and the third support surface 1231a of the second support member 1231.

According to various embodiments, an electronic device 100 may include one or more waterproof members 481, 482, 483, and 484 disposed between the first display 400 and the second support member 1231 and between the first display 400 and the first support member 1131. According to an embodiment, some 481, 482, and 483 of the one or more waterproof members 481, 482, 483, and 484 may include a first waterproof member 481 disposed between the first display 400 and the second support member 1231, a second waterproof member 482 connected to the first waterproof member 481, and a third waterproof member 483 that connects one end 4811 of the first waterproof member 481 and one end of the second waterproof member 482 and connects the other end 4812 of the first waterproof member 481 and the other end of the second waterproof member 482, thereby providing a first waterproof space 4813. In an embodiment, the first waterproof member 481, the second waterproof member 482, and/or the third waterproof member 483 may be formed integrally. According to an embodiment, a waterproof member 484 among the one or more waterproof members 481, 482, 483, and 484 may include a fourth waterproof member 484 in which a second waterproof space 4841 in a closed loop shape is provided between the first display 400 and the first support member 1131. According to an embodiment, a plurality of electronic elements including a control circuit of the first display 400 (e.g., a display driver IC (DDI)) may be disposed in a sealed first waterproof space 4813 defined by a first waterproof member 481, a second waterproof member 482, and a third waterproof member 483 between the first display 400 and the second support member 1231, thereby being protected from external moisture and/or foreign substances. According to an embodiment, one or more electronic components (e.g., a sensor module (e.g., the sensor module 104 in FIG. 1A) and/or a camera device (e.g., the camera device 105 in FIG. 1A) disposed via the first support member 1131 may be disposed in a second waterproof space 4841 defined by the closed loop shape of the fourth waterproof member 484 between the first display 400 and the first support member 1131, thereby being protected from external moisture and/or foreign substances. There is no limitation on the types of components disposed in the first waterproof space 4813 and/or the second waterproof space 4841 according to various embodiments.

According to various embodiments, an electronic device 100 may include one or more adhesive members 510 and 520 disposed between the first and second housings 110 and 120 and the first display 400 (e.g., a flexible display). According to an embodiment, the one or more adhesive members 510 and 520 may include a first adhesive member 510 disposed between the first housing 110 and the first display 400 and a second adhesive member 520 disposed between the second housing 120 and the first display 400. According to an embodiment, the one or more adhesive members 510 and 520 may be disposed longitudinally along the folding axis (e.g., the folding axis F in FIGS. 1A to 2B) in the crease areas (e.g., the first crease area 130d and the second crease area 130e in FIG. 5) formed adjacent to the folding area (e.g., the folding area 130c in FIG. 5). According to an embodiment, the one or more adhesive members 510 and 520 may be disposed to overlap an area corresponding to the crease areas formed on at least both sides of the folding area 130c when viewing the first display 400 from above (e.g., the first crease area 130d and the second crease area 130e in FIG. 5). According to an embodiment, the adhesive members 510 and 520 may be disposed to be attached to the rear surface of the first display 400 and the corresponding surfaces of the housings 110 and 120. According to an embodiment, the one or more adhesive members 510 and 520 may include at least one of double-sided tape, waterproof tape, an optical clear adhesive (OCA), a pressure-sensitive adhesive (PSA), a thermally reactive adhesive, or a general adhesive. According to an embodiment, a portion corresponding to a crease area (e.g., the first crease area 130d and the second crease area 130e in FIG. 5) of the first display 400 may be attached to the housings 110 and 120 via one or more adhesive members 510 and 520, thereby reducing the protrusion height of the crease areas (e.g., the first crease area 130d and the second crease area 130e in FIG. 5) protruding upward relative to the flat surface of the first display 400 in the unfolded state, and helping improve the surface quality of the first display 400.

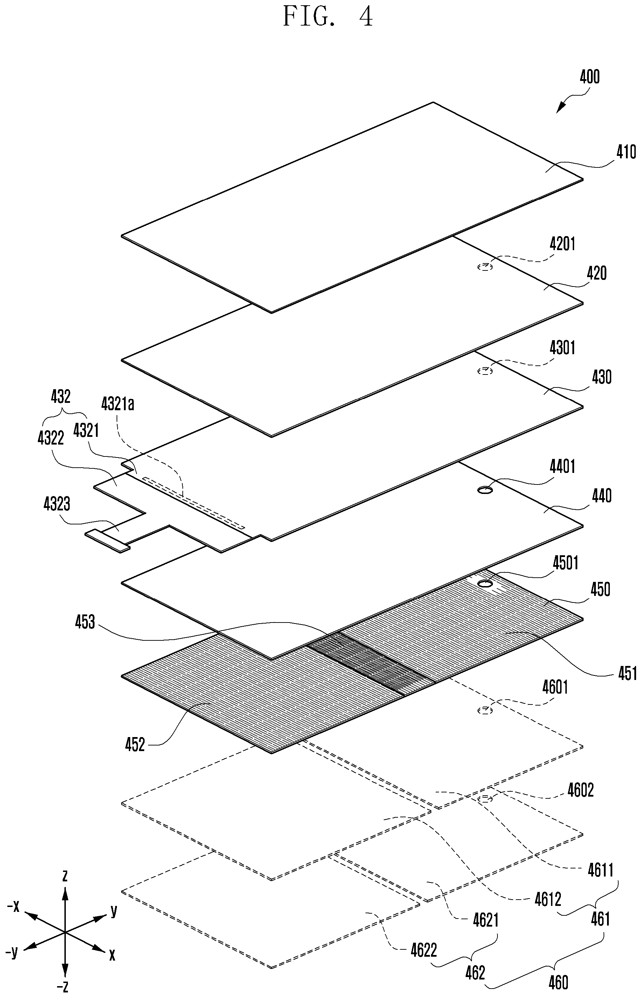

FIG. 4 is an exploded perspective view of a flexible display according to various embodiments of the disclosure.

The flexible display 400 of FIG. 4 may be at least partially similar to the first display 400 of FIG. 4A or may further include other embodiments of a flexible display.

A display (e.g., the flexible display 400) according to exemplary embodiments of the disclosure may include an unbreakable (UB)-type OLED display (e.g., a curved display). However, the disclosure is not limited thereto, and the flexible display 400 may include an on-cell-touch active-matrix organic light-emitting diode (AMOLED) (OCTA)-type flat display.

Referring to FIG. 4, the first display 400 (hereinafter referred to as a "flexible display") may include a window layer 410, and a polarizer (POL) 420 (e.g., a polarizing film), a display panel 430, a polymer layer 440, a support plate 450, and a functional layer 460, which are sequentially disposed on the rear surface of the window layer 410 (e.g., in the -z-axis direction). According to an embodiment, the functional layer 460 may include a reinforcement plate 462 and/or a digitizer 461. According to an embodiment, the reinforcement plate 462 may include a first reinforcement plate 4621 disposed at a position corresponding to the first housing (e.g., the first housing 110 in FIG. 1A) or a second reinforcement plate 4622 disposed at a position corresponding to the second housing (e.g., the second housing 120 in FIG. 1A). In some embodiments, the reinforcement plate 462 may be integrally formed. In some embodiments, the flexible display 400 may include a digitizer 461 disposed between the support plate 450 and the reinforcement plate 462. In some embodiments, the digitizer 461 may include a first digitizer 4611 positioned to correspond to a first housing (e.g., the first housing 110 in FIG. 1A) and a second digitizer 4612 electrically connected to the first digitizer and positioned to correspond to a second housing (e.g., the second housing 120 in FIG. 1A). In some embodiments, the digitizer 461 may be formed integrally. In some embodiments, the digitizer 461 may be disposed between the polymer layer 440 and the support plate 450. According to an embodiment, the digitizer 460 may include coil members disposed on a dielectric substrate (e.g., a dielectric film or a dielectric sheet) to detect an electromagnetically induced resonance frequency applied from an electronic pen. In some embodiments, when the flexible display 400 is a POL-less display, the polarizing layer may be omitted, and a transparent reinforcement layer (e.g., a buffer layer) may be further disposed on that position. In some embodiments, the polymer layer 440 and/or the reinforcement plate 462 may be omitted. In some embodiments, the polymer layer 440 may be disposed on the reinforcement plate 462.

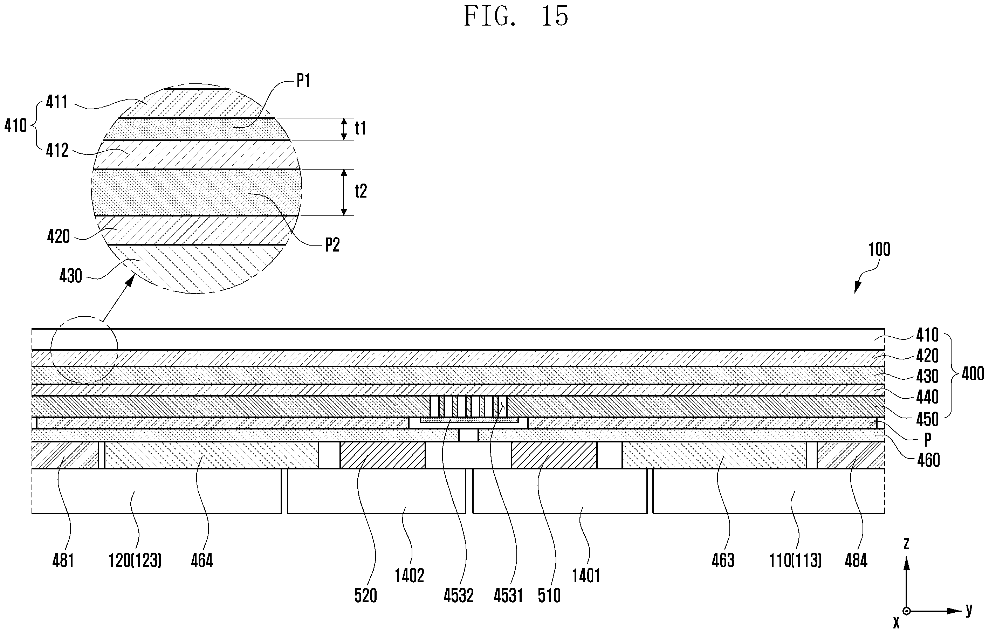

According to various embodiments, the window layer 410 may include a first layer (e.g., the first layer 411 in FIG. 15) and a second layer (e.g., the second layer 412 in FIG. 15) that are sequentially laminated. According to an embodiment, the first layer 411 may be made of a polymer (e.g., polyethylene terephthalate (PET), polyimide (PI), or thermoplastic polyurethane (TPU)). According to an embodiment, the second layer 412 may be made of glass. According to an embodiment, the second layer may include ultra-thin glass (UTG). In some embodiments, the flexible display 400 may further include a coating layer formed as a part of the window layer 410 and disposed on top of the first layer 411. In such cases, the coating layer may include a hard coating (HC) layer, an anti-reflection/low-reflection (AR/LR) coating layer, a shatter proof (SP) coating layer, or an anti-fingerprint (AF) coating layer. In some embodiments, the coating layer may be formed between the first layer 411 and the second layer 412, on at least one of the side surface of the first layer 411 and the rear surface or side surface of the second layer 412.

According to various embodiments, the window layer 410, the polarizer 420, the display panel 430, the polymer layer 440, and the support plate 450 may be disposed to cross at least a portion of the first surface (e.g., the first surface 111 in FIG. 1A) of the first housing (e.g., the first housing 110 in FIG. 1A) and the third surface (e.g., the third surface 121 in FIG. 1A) of the second housing (e.g., the second housing 120 in FIG. 1A). According to an embodiment, the reinforcement plate 462 may provide rigidity for the flexible display 400 and may be used as ground to prevent malfunction of the flexible display 400. According to an embodiment, the reinforcement plate 462 may be made of a metal material. According to an embodiment, the reinforcement plate 462 may be made of SUS or Al. According to an embodiment, the window layer 410, the polarizing layer 420, the display panel 430, the polymer layer 440, the support plate 450, and the reinforcement plate 462 may be attached to each other by an adhesive (or adhesive members). For example, the adhesive may include at least one of an optical clear adhesive (OCA), a pressure-sensitive adhesive (PSA), a heat-responsive adhesive, a general adhesive, or double-sided tape.

According to various embodiments, the display panel 430 may include multiple pixels and a wiring structure (e.g., an electrode pattern). According to an embodiment, the polarizer 420 may selectively make light, which is generated from a light source of the display panel 430 and vibrates in a predetermined direction, pass therethrough. According to an embodiment, the display panel 430 and the polarizer 420 may be integrally configured. According to an embodiment, when a color filter formed of red (R), green (G), and blue (B) pigments having a polarizing function is disposed on each of the pixels of the display panel 430, the polarizing layer 420 may be omitted. According to an embodiment, when a color filter having a polarizing function is applied, a light reflection blocking layer (e.g., a black pixel define layer (BPDL)) capable of preventing reflection of external light may be included inside the display panel 430. According to an embodiment, the flexible display 400 may include a touch panel (not illustrated).

According to various embodiments, the polymer layer 440 may be disposed under the display panel 430 to provide a dark background for securing visibility of the display panel 430, and may be made of a buffering material for a buffering action. In some embodiments, in order to ensure waterproofing of the flexible display 400, the polymer layer 440 may be removed or disposed under the support plate 450. In some embodiments, the polymer layer 440 may be omitted when the support plate 450 is made of an opaque material.

According to various embodiments, the support plate 450 may provide a bendable property to the flexible display 400. For example, the support plate 450 may be made of a non-metallic sheet material, such as fiber reinforced plastics (FRP) (e.g., carbon fiber reinforced plastics (CFRP) or glass fiber reinforced plastics (GFRP)), having a rigid property to support the display panel 430. According to an embodiment, the support plate 450 may include a first flat portion 451 corresponding to the first housing (e.g., the first housing 110 in FIG. 1A), a second flat portion 452 corresponding to the second housing (e.g., the second housing 120 in FIG. 1A), and a flexible portion 453 (or a bending portion) interconnecting the first flat portion 451 and the second flat portion 452. According to an embodiment, the flexible portion 453 may include a plurality of openings formed to penetrate from the top surface to the rear surface of the support plate 450 and/or a plurality of recesses formed in a portion of the top surface and/or a portion of the rear surface in order to improve the bendability. According to an embodiment, the bending property of the flexible portion 453 may be determined through at least one of the size, shape, or arrangement density of at least some of the plurality of openings and/or at least some of the plurality of recesses. In some embodiments, the support plate 450 may be made of a metal material such as steel use stainless (SUS) (e.g., stainless steel (STS)), Cu, Al, or a metal CLAD (e.g., a laminated member in which SUS and Al are alternately disposed). In this case, throughout the entire area of the support plate 450, the multiple openings may be formed to induce the detection operation of the digitizer 461 disposed under the support plate. According to an embodiment, the support plate 450 may help reinforce the rigidity of the electronic device (e.g., the electronic device 100 in FIG. 1A), and may be used to shield ambient noise and dissipate heat emitted from surrounding heat dissipating components.

According to various embodiments, the flexible display 400 may include at least one auxiliary material layer (not illustrated) disposed between the polymer layer 440 and the support plate 450 or under the support plate 450. According to an embodiment, the at least one auxiliary material layer may include a graphite sheet for heat dissipation, a force-touch FPCB, a fingerprint sensor FPCB, an antenna radiator for communication, or a conductive/non-conductive tape. According to an embodiment, the at least one auxiliary material layer may be replaced with the functional layer 460 including the aforementioned digitizer 461 and/or reinforcement plate 462. According to an embodiment, when the at least one auxiliary layer is not bendable, the auxiliary layer may be separately disposed in the first housing (e.g., the first housing 110 in FIG. 1A) and the second housing (e.g., the second housing 120 in FIG. 1A). According to an embodiment, when the at least one auxiliary material layer is bendable, the auxiliary material may be disposed from the first housing (e.g., the first housing 110 in FIG. 1A) to at least a portion of the second housing (e.g., the second housing 120 in FIG. 1A) across the hinge device (e.g., the hinge device 140 in FIG. 3).

According to various embodiments, the flexible display 400 may include a bending portion 432 disposed to be folded from the display panel 430 to at least a portion of the rear surface (e.g., the -z-axis direction) of the flexible display 400. According to an embodiment, the bending portion 432 may include an extension 4321 extending from the display panel 430 and including a control circuit 4321a, and a flexible printed circuit board (FPCB) 4322 electrically connected to the extension 4321 and including a plurality of electrical elements. According to an embodiment, the control circuit 4321a may include a display driver IC (DDI) or a touch display driver IC (TDDI) mounted on the extension 4321 having an electrical wiring structure. According to an embodiment, the bending portion 432 may include a COP (chip-on-panel or chip-on-plastic) structure in which the control circuit 4321a is directly disposed on the extension 4321. In some embodiments, the bending portion 432 may include a chip-on-film (COF) structure in which the control circuit 4321a is mounted on a separate connection film (not illustrated) interconnecting the extension 4321 and the flexible board 4322. According to an embodiment, the flexible display 400 may include a plurality of electronic elements disposed on the flexible board 4322. According to an embodiment, the plurality of electrical elements may include passive elements such as a touch IC, a display flash memory, an ESD prevention diode, a pressure sensor, a fingerprint sensor, or a decap. According to an embodiment, the flexible display 400 may include an FPCB connection portion 4323 (e.g., a connector) extending from the flexible board 4322 and electrically connected to a board (e.g., the second board 162 in FIG. 3) of the electronic device (e.g., the electronic device 100 in FIG. 3). As another embodiment, when the bending portion 432 is disposed in an area of the flexible display 400 facing the first housing (e.g., the first housing 110 in FIG. 1A), the FPCB connection portion 4323 may be electrically connected to another board (e.g., the first board 161 in FIG. 3) of the electronic device (e.g., the electronic device 100 in FIG. 3).

According to various embodiments, the flexible display 400 may include perforated openings 4201, 4301, 4401, 4501, 4601, and 4602disposed in each of the layers 420, 430, 440, 450, and 460and corresponding to electronic components (e.g., camera devices) disposed thereunder. In some embodiments, the display panel 430 and the polarizing layer 420 may not require perforated openings.

An electronic device (e.g., the electronic device 100 of FIG. 3) according to exemplary embodiments of the disclosure may include one or more adhesive members (e.g., the adhesive members 510 and 520 in FIG. 3) disposed between the functional layer (e.g., the functional layer 460 in FIG. 5) (e.g., the digitizer 461 and/or the reinforcement plate 462) disposed under the support plate 450 of the flexible display 400 and the housings (e.g., the first housing 110 and the second housing 120 in FIG. 3). According to an embodiment, the one or more adhesive members 510 and 520 may include double-sided tape or double-sided waterproof tape that attaches the functional layer (e.g., the functional layer 460 in FIG. 5) and the housings (e.g., the first housing 110 and the second housing 120 in FIG. 3). According to an embodiment, the one or more adhesive members 510 and 520 may be disposed longitudinally along the folding axis (e.g., the folding axis F in FIGS. 1A to 2B) in an area corresponding to the crease areas (e.g., the first crease area 130d and the second crease area 130e in FIG. 5) formed adjacent to the folding area (e.g., the folding area 130c in FIG. 5) of the flexible display 400 and may attach the functional layer (e.g., the functional layer 460 in FIG. 5) and the housings (e.g., the first housing 110 and the second housing 120 in FIG. 3) to each other, thereby reducing the protrusion heights of the crease areas (e.g., the first crease area 130d and the second crease area 130e in FIG. 5) protruding upward relative to the flat surface of the flexible display 400, and helping improve the surface quality of the flexible display 400. In some embodiments, when the functional layer (e.g., the functional layer 460 in FIG. 5) is omitted, the one or more adhesive members 510 and 520 may be disposed between the support plate 450 and the housings 110 and 120.

FIG. 5 is a partial cross-sectional view of the electronic device according to various embodiments of the disclosure taken along line 5-5 in FIG. 1A.

Referring to FIG. 5, the electronic device 100 may include a first housing 110 including a first side surface member 113, a second housing 120 including a second side surface member 123 and connected to the first housing 120 to be foldable about a folding axis F via a hinge device (e.g., the hinge device 140 in FIG. 3), and a flexible display 400 disposed to be supported by the first housing 110 and the second housing 120. According to an embodiment, the first housing 110 may include a first hinge plate 1401 connected to the hinge device 140, and the second housing 120 may include a second hinge plate 1402 connected to the hinge device 140. Accordingly, when the electronic device 100 is in the unfolded state, the first housing 110, the first hinge plate 1401, the second hinge plate 1402, and the second housing 120 may form substantially the same plane, thereby supporting the flexible display 400. In some embodiments, the first housing 110 may be directly connected to the hinge device 140 without the first hinge plate 1401, and the second housing 120 may be directly connected to the hinge device 140 without the second hinge plate 1402.

According to various embodiments, the flexible display 400 may include a window layer 410, and a polarizing layer 420, a display panel 430, a polymer layer 440, and a support plate 450, which are sequentially disposed under the window layer 410. According to an embodiment, the support plate 450 may include a pattern 4531 including a plurality of openings formed at predetermined intervals in the folding area 130c to provide flexibility to the flexible display 400. In some embodiments, the pattern 4531 may be replaced with a plurality of recesses formed lower than the outer surface. In some embodiments, the pattern 4531 may be configured in a form in which a plurality of openings and a plurality of recesses are combined. According to an embodiment, the flexible display 400 may include a blocking member 4532 disposed in an area corresponding to the folding area 130c under the support plate 450 to block the plurality of openings of the pattern 4531. According to an embodiment, the blocking member 4532 may include a thermoplastic polyurethane (TPU) attached to the support plate 450. According to an embodiment, the electronic device may include a functional layer 460 disposed under the flexible display. In this case, the functional layer may be at least partially attached to the support plate via an adhesive P. According to an embodiment, the functional layer 460 may include a digitizer (e.g., the digitizer 461 in FIG. 4) and/or a reinforcement plate (e.g., the reinforcement plate 462 in FIG. 4).

According to various embodiments, the flexible display 400 may include crease areas 130d and 130e formed longitudinally along the folding axis F on both sides of the folding area 130c through folding and unfolding operations. According to an embodiment, the crease areas 130d and 130e may include a first crease area 130d formed at a position corresponding to at least a portion of the first housing 110 on one side of the folding area 130c, and a second crease area 130e formed at a position corresponding to at least a portion of the second housing 120 on the other side of the folding area 130c. In some embodiments, the first crease area 130d and the second crease area 130e may be formed in a portion of the folding area 130c. As illustrated, when the electronic device 100 is in the unfolded state, the folding area 130c may sag downward (e.g., in the -z-axis direction) from the flat line L of the flexible display 400, and the first crease area 130d and the second crease area 130e may protrude upward (e.g., in the z-axis direction) relative to the flat line L of the flexible display 400. Thus, the surface quality of the flexible display 400 may be deteriorated. The exemplary embodiments of the disclosure may help improve the surface quality by having an attachment structure for reducing the vertical distance h from the highest position of the crease areas 130d and 130e of the flexible display 400 to the lowest position of the folding area 130c.

According to various embodiments, the electronic device 100 may include one or more adhesive members 510 and 520 disposed between the flexible display 400 and the housings 110 and 120. For example, the one or more adhesive members 510 and 520 may include a first adhesive member 510 disposed between the functional layer 460 and the first housing 110 (and/or the first hinge plate 1401), and a second adhesive member 520 disposed between the functional layer 460 and the second housing 120 (and/or the second hinge plate 1402). According to an embodiment, the first adhesive member 510 may be disposed in a section overlapping at least the first crease area 130d when the flexible display 400 is viewed from above. According to an embodiment, the second adhesive member 520 may be disposed in a section overlapping at least the second crease area 130e when the flexible display 400 is viewed from above. According to an embodiment, the first adhesive member 510 and the second adhesive member 520 may be disposed along the longitudinal direction (e.g., in the x-axis direction) of the folding axis F of the flexible display 400 at a position corresponding to at least a portion of the crease areas 130d and 130e adjacent to the folding axis F, thereby attaching the functional layer 460 and the housings 110 and 120 to each other. According to an embodiment, the electronic device 100 may include graphite 463 for heat dissipation and a waterproof member 484 (e.g., the fourth waterproof member 484 in FIG. 3) for waterproofing disposed between the functional layer 460 and the first housing 110 in at least a portion, other than the first adhesive member 510. According to an embodiment, the electronic device 100 may include a buffer member 464 for buffering and a waterproof member 481 (e.g., the first waterproof member 481 in FIG. 3) for waterproofing disposed between the functional layer 460 and the second housing 120 in at least a portion, other than the second adhesive member 520. According to an embodiment, the buffer member 464 may be disposed to be attached to the second housing 120 and to come into contact with the functional layer 460.

When the electronic device 100 is in the unfolded state, the attachment structure of the section corresponding to the crease areas 130d and 130e via the adhesive members 510 and 520 according to the exemplary embodiment of the disclosure may cause the crease areas 130d and 130e protruding upward relative to the flat line L of the flexible display 400 to be pulled downward (e.g., in the -z-axis direction), thereby reducing the protrusion height and helping improve the surface quality of the flexible display 400. In some embodiments, the first adhesive member 510 and the second adhesive member 520 may be integrated. In this case, the integrated adhesive members 510 and 520 may be disposed to be at least partially cross the folding area 130c.

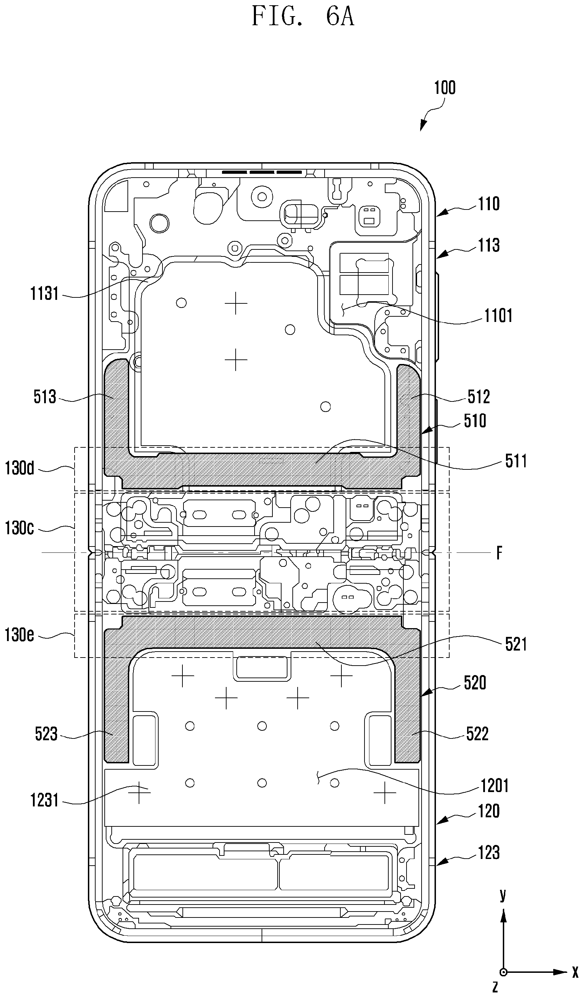

FIGS. 6A to 6H are plan views illustrating an electronic device with various arrangement structures of adhesive members according to various embodiments of the disclosure.

The electronic device 100 is illustrated in FIGS. 6A to 6H in a state in which a flexible display 400 is omitted.

Referring to FIG. 6A, the electronic device 100 may include a first housing 110 including a first side surface member 113, a second housing 120 including a second side surface member 123 and foldably connected to the first housing 120 via a hinge device (e.g., the hinge device 140 in FIG. 3), and a flexible display (e.g., the flexible display 400 in FIG. 5) disposed to be supported by the first housing 110 and the second housing 120. According to an embodiment, the first side surface member 113 may include a first support member 1131 extending into a first space 1101 in the first housing 110. According to an embodiment, the second side surface member 123 may include a second support member 1231 extending into a second space 1201 in the second housing 120. According to an embodiment, the electronic device 100 may display an image in portions of the above-described flexible display 400 corresponding to the folding area 130c, the first folding area 130d, and the second folding area 130e.

According to various embodiments, the electronic device 100 may include a first adhesive member 510 disposed on the first support member 1131 of the first housing 110 and a second adhesive member 520 disposed on the second support member 1231 of the second housing 120. According to an embodiment, the first adhesive member 510 may include a first portion 511 overlapping the first crease area 130d when viewing the flexible display 400 from above, a second portion 512 extending from one end of the first portion 511 to the first space 1101, and a third portion 513 extending from the other end of the first portion 511 to the first space 1101. According to an embodiment, the second adhesive member 520 may be disposed in a symmetrical structure with the first adhesive member 510. According to an embodiment, the second adhesive member 520 may include a fourth portion 521 overlapping the second crease area 130e when viewing the flexible display 400 from above, a fifth portion 522 extending from one end of the fourth portion 521 to the second space 1201, and a sixth portion 523 extending from the other end of the fourth portion 521 to the second space 1201. According to an embodiment, the first crease area 130d and the second crease area 130e of the flexible display 400 may be pulled downward (e.g., in the -z-axis direction) in the unfolded state by the first portion 511 of the first adhesive member 510 and the fourth portion 521 of the second adhesive member 520 disposed at positions overlapping the first and second crease areas 130d and 130e, thereby helping improve the surface quality of the flexible display 400. According to an embodiment, the second portion 512, the third portion 513, the fifth portion 522, and the sixth portion 523 may help ensure stable operation of the electronic device 100 by expanding the bonding area between the flexible display 400 and the housings 110 and 120.

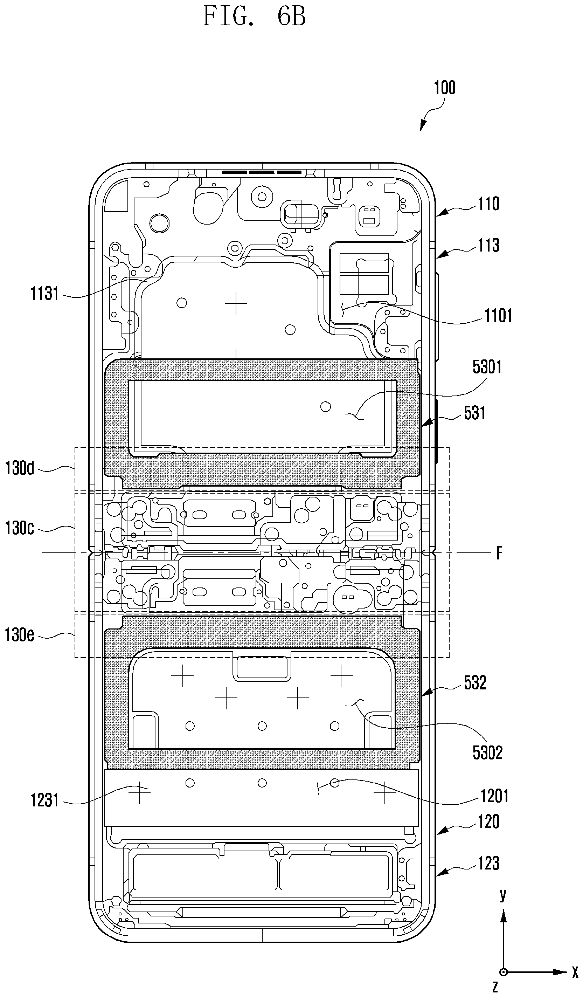

Hereinafter, in describing the electronic device 100 in FIGS. 6B to 6H, the components that are substantially the same as those of the electronic device 100 of FIG. 6A may be assigned with the same reference numerals, and a detailed description thereof may be omitted. In addition, as illustrated in FIGS. 6B to 6H, adhesive members 531, 532, 533, 534, 535, 536, 537, 538, 539, 540, 541, and 542 may have various shapes that are modified according to the arrangement design of various structures (e.g., graphite, waterproof members, or one or more electronic components) disposed in the inner spaces 1101 and 1201 of the electronic device 100.

Referring to FIG. 6B, the electronic device 100 may include a first adhesive member 531 disposed at a position at least partially corresponding to the first crease area 130d of the flexible display 400 and a second adhesive member 532 disposed at a position at least partially corresponding to the second crease area 130e. According to an embodiment, the first adhesive member 531 may be formed in a closed loop shape to have a first sealed space 5301, and the second adhesive member 532 may be formed in a closed loop shape to have a second sealed space 5302. In this case, the first sealed space 5301 and the second sealed space 5302 may be utilized as waterproof spaces for one or more electronic components.

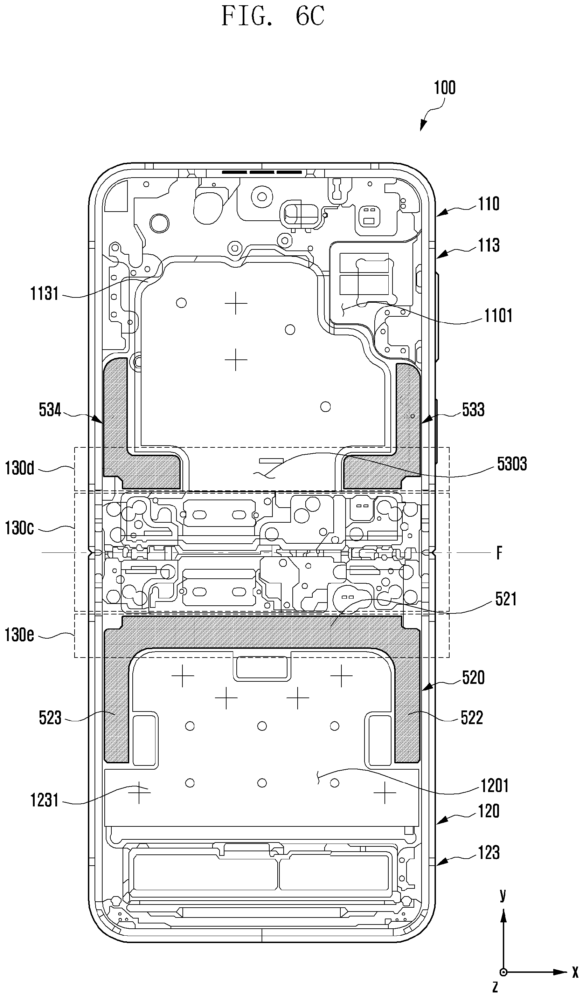

Referring to FIG. 6C, the electronic device 100 may include a first adhesive member 533 and a second adhesive member 534 disposed at a position at least partially corresponding to at least a first crease area 130d of the flexible display 400. According to an embodiment, the first adhesive member 533 and the second adhesive member 534 may be disposed in an area corresponding to the first crease area 130d to have a first separation space 5303 therebetween. According to an embodiment, the electronic device 100 may include a third adhesive member 520 formed in a shape substantially identical to the second adhesive member 520 of FIG. 6A and disposed at a position corresponding to the second crease area 130e. According to an embodiment, the first separation space 5303 may be utilized as an expanded attachment space for a heat dissipation member such as graphite (e.g., the graphite 463 of FIG. 5) disposed in the first housing 110.

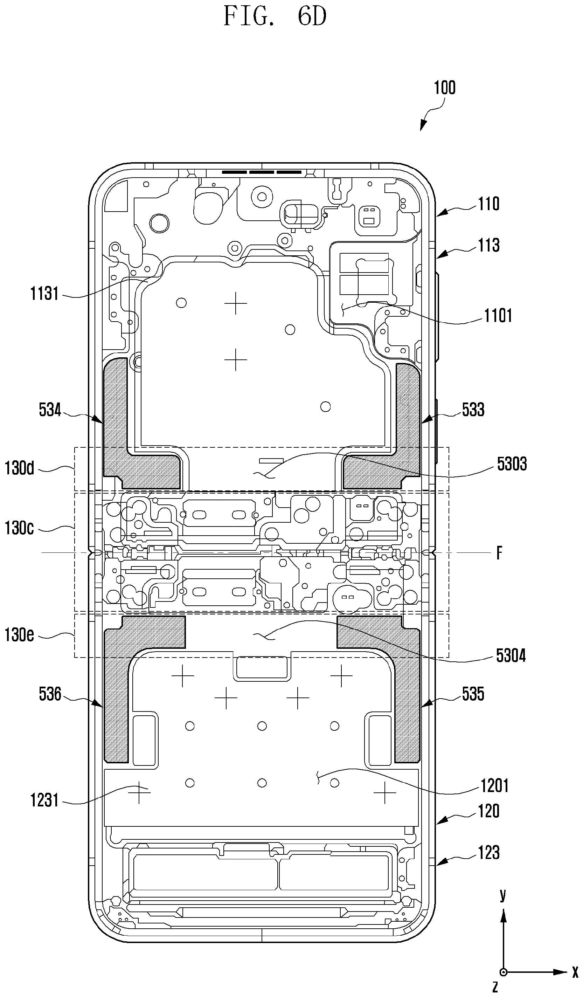

Referring to FIG. 6D, the electronic device 100 may include a first adhesive member 533 and a second adhesive member 534 formed in substantially the same shape as the first adhesive member 533 and the second adhesive member 534 of FIG. 6C, and disposed to have a first separation space 5303 at a position corresponding to the first crease area 130d. According to an embodiment, the electronic device 100 may include a third adhesive member 535 and a fourth adhesive member 536 substantially symmetrically disposed with respect to the first adhesive member 533 and the second adhesive member 534 in an area corresponding to the second crease area 130e. According to an embodiment, the third adhesive member 535 and the fourth adhesive member 536 may be disposed in an area corresponding to the second crease area 130e to have a second separation space 5304. According to an embodiment, the first separation space 5303 may be utilized as an expanded attachment space for a heat dissipation member such as graphite (e.g., the graphite 463 of FIG. 5) disposed in the first housing 110. According to an embodiment, the second separation space 5304 may be utilized as an expanded attachment space for a buffer member (e.g., the buffer member 464 in FIG. 5) disposed in the second housing 120.

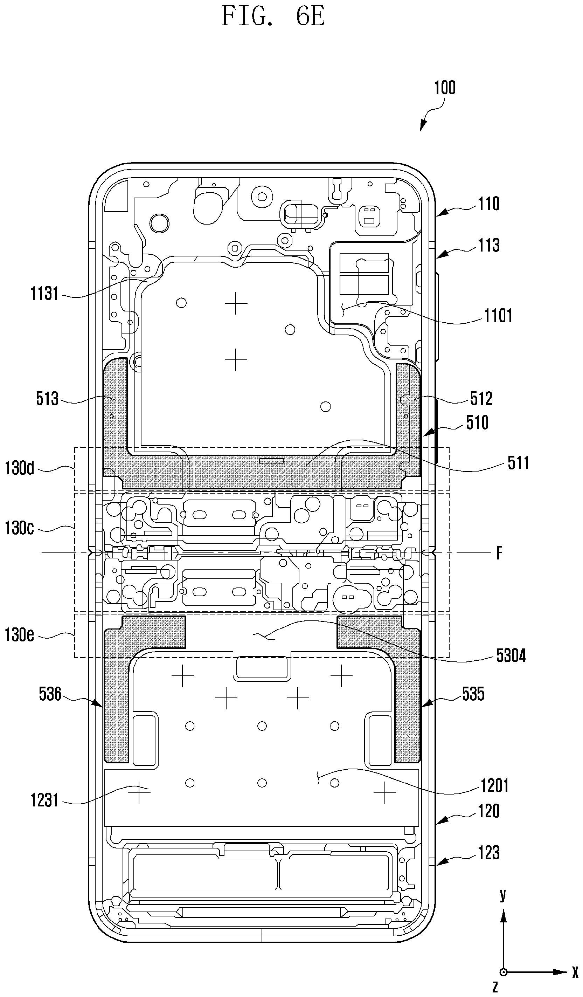

Referring to FIG. 6E, the electronic device may include a first adhesive member 520 formed in substantially the same shape as the first adhesive member 510 of FIG. 6A and disposed to at least partially overlap the first crease area 130d. According to an embodiment, the electronic device may include a second adhesive member 535 and a third adhesive member 536 formed in substantially the same shape as the third adhesive member 535 and the fourth adhesive member 536 of FIG. 6D, and disposed to have a separation space 5304 at a position corresponding to the second crease area 130e.

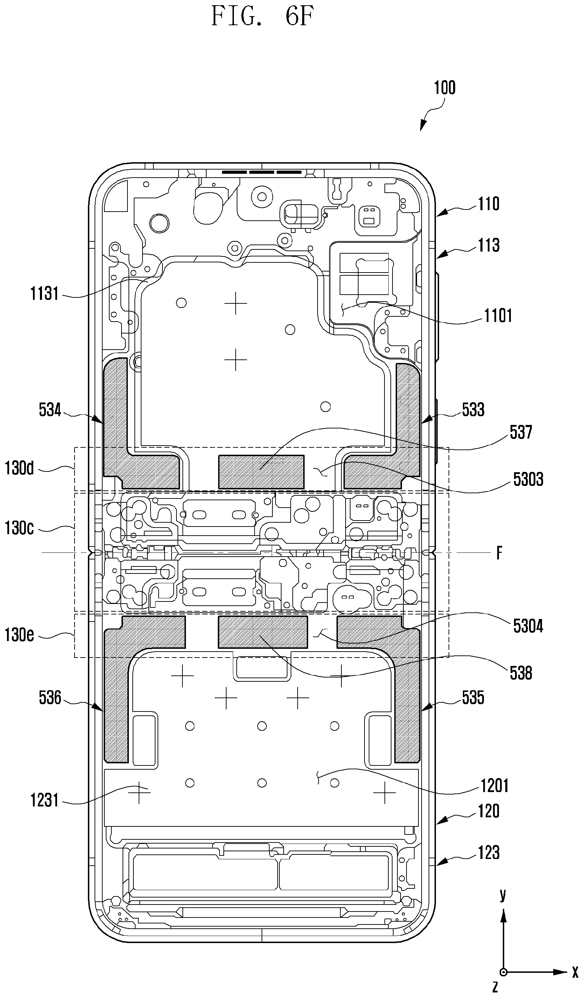

Referring to FIG. 6F, the electronic device 100 may include a fifth adhesive member 537 disposed in the first separation space 5303 between the first adhesive member 533 and the second adhesive member 534 of FIG. 6D in an area corresponding to the first crease area 130d. According to an embodiment, the electronic device 100 may include a sixth adhesive member 538 disposed in the second separation space 5304 between the third adhesive member 535 and the fourth adhesive member 536 of FIG. 6D in an area corresponding to the second crease area 130e.

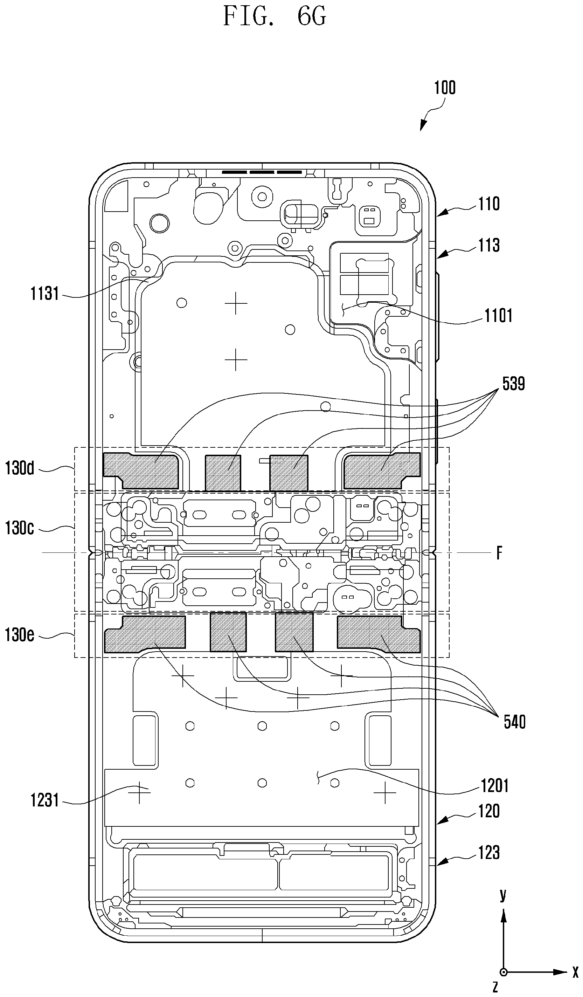

Referring to FIG. 6G, the electronic device 100 may include a plurality of first adhesive members 539 disposed at a predetermined interval in an area corresponding to the first crease area 130d and a plurality of second adhesive members 540 disposed at a predetermined interval in an area corresponding to the second crease area 130e.

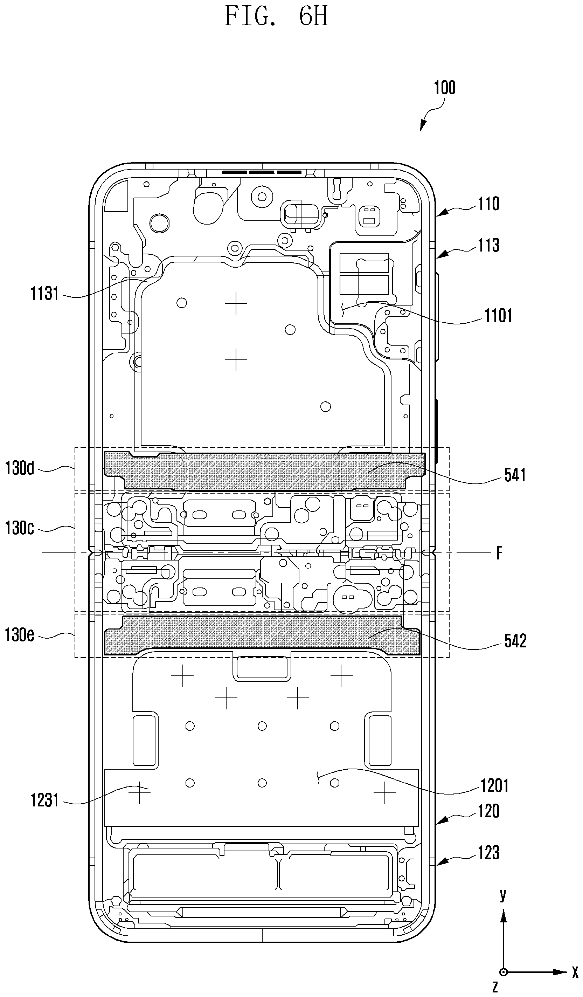

Referring to FIG. 6H, the electronic device 100 may also include a first adhesive member 541 disposed only in an area corresponding to the first crease area 130d and a second adhesive member 542 disposed only in an area corresponding to the second crease area 130e.

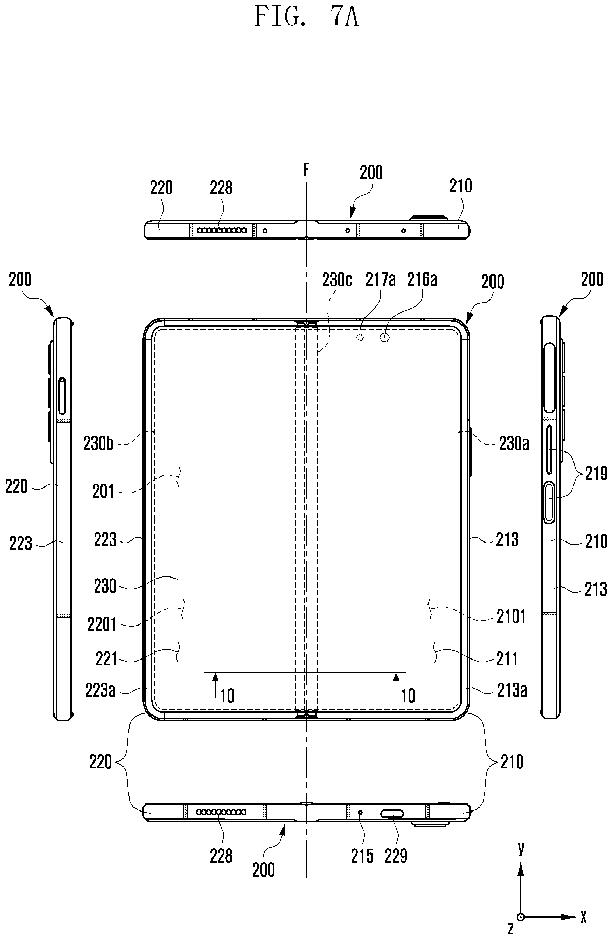

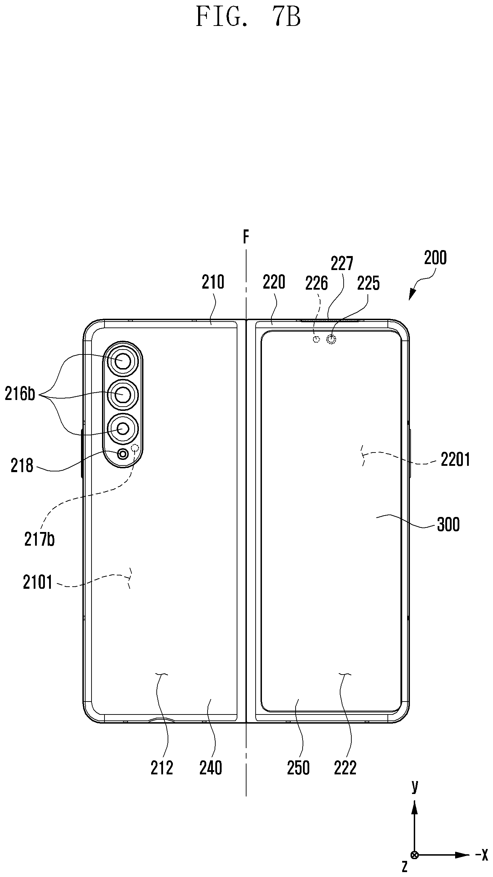

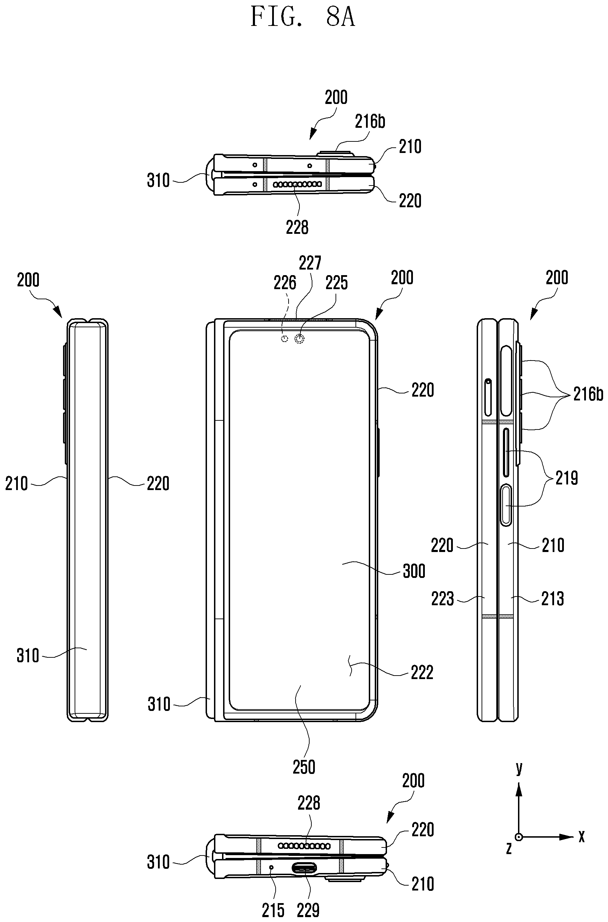

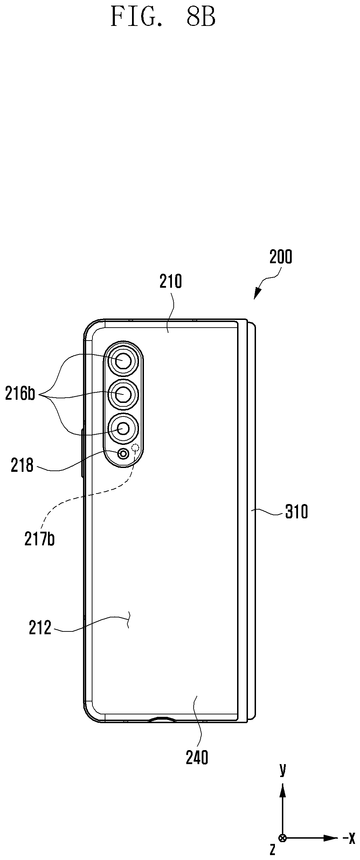

FIGS. 7A and 7B are front and rear views of an electronic device according to various embodiments of the disclosure in an unfolded state. FIGS. 8A and 8B are front and rear views of the electronic device according to various embodiments of the disclosure in a folded state.

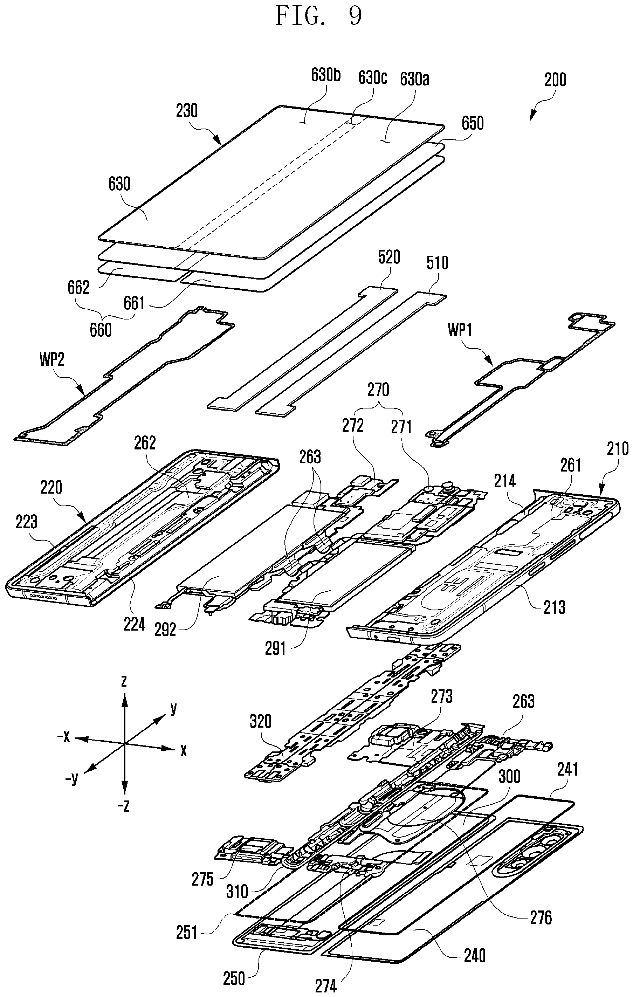

Referring to FIGS. 7A to 8B, an electronic device 200 may include a pair of housings 210 and 220 (e.g., a foldable housing structure) coupled to each other via a hinge device (e.g., the hinge device 320 in FIG. 9) (e.g., a hinge module) to be rotatable about a folding axis F so as to be foldable relative to each other, a first display 230 (e.g., a flexible display, a foldable display, or a main display) disposed on the pair of housings 210 and 220, and/or a second display 300 (e.g., a sub-display) disposed on a second housing 220. According to an embodiment, at least a portion of the hinge device (e.g., the hinge device 320 in FIG. 9) may be disposed to be invisible from the outside through the first housing 210 and the second housing 220, and may be disposed to be invisible from the outside through a hinge housing 310, which covers a foldable portion, in the unfolded state. According to an embodiment, the hinge device (e.g., the hinge device 320 in FIG. 9) may include a gear assembly including a plurality of gears, a hinge module including a hinge module including a plurality of hinge cams coupled to hinge shafts rotating via the gear assembly and configured to perform a cam interlocking operation, and hinge plates interconnecting the hinge module and the first and second housings 210 and 220. Herein, the surface on which the first display 230 is disposed may be defined as the front surface of the electronic device 200, and the surface opposite to the front surface may be defined as the rear surface of the electronic device 200. **In** addition, the surface surrounding the space between the front surface and the rear surface may be defined as the side surface of the electronic device 200.

According to various embodiments, the pair of housings 210 and 220 may include a first housing 210 and a second housing 220 that are disposed to be foldable with respect to each other via the hinge device (e.g., the hinge device 320 in FIG. 9). According to an embodiment, the pair of housings 210 and 220 are not limited to the shape and assembly illustrated in FIGS. 7A to 8B, but may be implemented by other shapes or other combinations and/or assemblies of components. According to an embodiment, the first housing 210 and the second housing 220 may be disposed on opposite sides of the folding axis F and may have shapes that are generally symmetrical to each other with respect to the folding axis F. According to some embodiments, the first housing 210 and the second housing 220 may be folded asymmetrically with respect to the folding axis F. According to an embodiment, the first housing 210 and the second housing 220 may form an angle or have a distance therebetween, which may be variable depending on whether the electronic device 200 is in the unfolded state, in the folded state, or in the intermediate state.

According to various embodiments, when the electronic device 200 is in the unfolded state, the first housing 210 may include a first surface 211 connected to the hinge device (e.g., the hinge 320 in FIG. 9) and arranged to face the forward direction of the electronic device 200, a second surface 212 facing a direction opposite to the direction of the first surface 211, and/or a first side surface member 213 surrounding at least a portion of a first space 2101 between the first surface 211 and the second surface 212. According to an embodiment, when the electronic device 200 is in the unfolded state, the second housing 220 may include a third surface 221 connected to the hinge device (e.g., the hinge 320 in FIG. 9) and arranged to face the forward direction of the electronic device 200, a fourth surface 222 facing a direction opposite to the direction of the third surface 221, and/or a second side surface member 223 surrounding at least a portion of a second space 2201 between the third surface 221 and the fourth surface 222. According to an embodiment, the first surface 211 may be oriented in substantially the same direction as the third surface 221 in the unfolded state and may at least partially face the third surface 221 in the folded state. According to an embodiment, the electronic device 200 may include a recess 201 provided to accommodate the first display 230 through structural coupling between the first housing 210 and the second housing 220. According to an embodiment, the recess 201 may have substantially the same size as the first display 230. According to an embodiment, the first housing 210 may include a first protection frame 213a (e.g., a first decoration member) which is coupled to the first side surface member 213 and disposed to overlap the edges of the first display 230 when the first display 230 is viewed from above, thereby covering the edges of the first display 230 to be invisible from the outside. According to an embodiment, the first protection frame 213a may be integrated with the first side surface member 213. According to an embodiment, the second housing 220 may include a second protection frame 223a (e.g., a second decoration member) which is coupled to the second side surface member 223 and disposed to overlap the periphery of the first display 230 when the first display 230 is viewed from above, thereby covering the periphery of the first display 230 to be invisible from the outside. According to an embodiment, the second protection frame 223a may be integrated with the second side surface member 223. **In** some embodiments, the first protection frame 213a and the second protection frame 223a may be omitted.

According to various embodiments, the hinge housing 310 (e.g., a hinge cover) may be disposed between the first housing 210 and the second housing 220 and disposed to cover a portion (e.g., at least one hinge module) of the hinge device (e.g., the hinge device 320 in FIG. 9) disposed in the hinge housing 310. According to an embodiment, the hinge housing 310 may be covered by a portion of the first housing 210 and the second housing 220 or exposed to the outside, depending on whether the electronic device 200 is in the unfolded state, the folded state, or the intermediate state. For example, when the electronic device 200 is in the unfolded state, at least a portion of the hinge housing 310 may not be substantially exposed by being disposed to be covered by the first housing 210 and the second housing 220. According to an embodiment, when the electronic device 200 is in the folded state, at least a portion of the hinge housing 310 may be disposed between the first housing 210 and the second housing 220 to be exposed to the outside. According to an embodiment, when the electronic device is in the intermediate state in which the first housing 210 and the second housing 220 are folded with a certain angle, the hinge housing 310 may be disposed between the first housing 210 and the second housing 220 to be at least partially exposed to the outside of the electronic device 200. For example, the area of the hinge housing 310 exposed to the outside may be smaller than that in the case where the electronic device is fully folded. According to an embodiment, the hinge housing 310 may include a curved surface.

According to various embodiments, when the electronic device 200 is in the unfolded state (e.g., the state in FIGS. 7A and 7B), the first housing 210 and the second housing 220 form an angle of about 180 degrees therebetween, and the first area 230a, the second area 230b, and the folding area 230c of the first display 230 may be arranged to be oriented in substantially the same direction (e.g., the z-axis direction) while substantially forming the same plane. As another embodiment, when the electronic device 200 is in the unfolded state, the first housing 210 may rotate by an angle of about 360 degrees with respect to the second housing 220 to be folded in the opposite direction such that the second surface 212 and the fourth surface 222 face each other (out-folding type).

According to various embodiment, when the electronic device 200 is in the folded state (e.g., the state in FIGS. 8A and 8B), the first surface 211 of the first housing 210 and the third surface 221 of the second housing 220 may be disposed to face each other. In this case, the first area 230a and the second area 230b of the first display 230 may form a narrow angle (e.g., in the range of 0 degrees to about 10 degrees) with respect to each other via the folding area 230c, and may be disposed to face each other. According to an embodiment, at least a portion of the folding area 230c may be transformed into a curved shape with a predetermined curvature. According to an embodiment, when the electronic device 200 is in the intermediate state, the first housing 210 and the second housing 220 may be disposed to form a certain angle therebetween. In this case, the first area 230a and the second area 230b of the first display 230 may form an angle that is greater than that in the folded state and smaller than that in the unfolded state, and the curvature of the folding area 230c may be smaller than that in the folded state and greater than that in the unfolded state. In some embodiments, the first housing 210 and the second housing 220 may form an angle at which the first housing 210 and the second housing 220 can be stopped to form a predetermined folding angle between the folded state and the unfolded state via the hinge device (e.g., the hinge device 320 in FIG. 9) (free stop function). In some embodiments, the first housing 210 and the second housing 220 may be continuously operated while being pressed in the unfolding direction and the folding direction with reference to a predetermined inflection angle via the hinge device (e.g., the hinge device 320 in FIG. 9).

According to various embodiments, the electronic device 200 may include at least one of the following components: one or more displays 230 and 300, input devices 215, sound output devices 227 and 228, sensor modules 217a, 217b, and 226, camera modules 216a, 216b, and 225, key input devices 219, indicators (not illustrated), or connector ports 229, in which the components are disposed on or in the first housing 210 and/or the second housing 220. In some embodiments, at least one of the components may be omitted from the electronic device 200, or at least one other component may be additionally included in the electronic device 200.

According to various embodiments, the one or more displays 230 and 300 may include a first display 230 (e.g., a flexible display) arranged to be supported by the first surface 211 of the first housing 210 to the third surface 221 of the second housing 220 across the hinge device (e.g., the hinge device 320 in FIG. 9), and a second display 300 disposed in the inner space of the second housing 220 to be at least partially visible from the outside through the fourth surface 222. In some embodiments, the second display 300 may be disposed in the inner space of the first housing 210 to be visible from the outside through the second surface 212. According to an embodiment, the first display 230 may be mainly used when the electronic device 200 is in the unfolded state, and the second display 300 may be mainly used when the electronic device 200 is in the folded state. According to an embodiment, when the electronic device 200 is in the intermediate state, the electronic device 200 may be controlled such that the first display 230 and/or the second display 300 can be used based on the folding angle between the first housing 210 and the second housing 220.

According to various embodiments, the first display 230 may be disposed in an accommodation space defined by the pair of housings 210 and 220. For example, the first display 200 may be disposed in the recess 201 defined by the pair of housings 210 and 220, and may be disposed to occupy substantially most of the front surface of the electronic device 200 in the unfolded state. According to an embodiment, the first display 230 may include a flexible display, at least a portion of which is transformable into a flat shape or a curved shape. According to an embodiment, the first display 230 may include a first area 230a facing the first housing 210 and a second area 230b facing the second housing 220. According to an embodiment, the first display 230 may include a folding area 230c including a portion of the first area 230a and a portion of the second area 230b with reference to the folding axis F. According to an embodiment, at least a portion of the folding area 230c may include an area corresponding to a hinge device (e.g., the hinge device 320 in FIG. 9). According to an embodiment, the area division of the first display 230 is only an exemplary physical division by the pair of housings 210 and 220 and the hinge device (e.g., the hinge device 320 in FIG. 9), and the first display 230 may display a seamless single entire screen substantially with the pair of housings 210 and 220 and the hinge device (e.g., the hinge device 320 in FIG. 9). According to an embodiment, the first area 230a and the second area 230b may have an overall symmetrical shape or a partially asymmetrical shape with respect to the folding area 230c.

According to various embodiments, the electronic device 200 may include a first rear surface cover 240 disposed on the second surface 212 of the first housing 210 and a second rear surface cover 250 disposed on the fourth surface 222 of the second housing 220. In some embodiments, at least a portion of the first rear surface cover 240 may be formed integrally with the first side surface member 213. In some embodiments, at least a portion of the second rear surface cover 250 may be integrated with the second side surface member 223. According to an embodiment, at least one of the first rear surface cover 240 and the second rear surface cover 250 may be made of a substantially transparent plate (e.g., a glass plate including various coating layers, or a polymer plate) or an opaque plate. According to an embodiment, the first rear surface cover 240 may be made of, for example, coated or colored glass, ceramic, polymer, metal (e.g., aluminum, stainless steel (STS), or magnesium), or an opaque plate such as a combination of two or more of these materials. According to an embodiment, the second rear surface cover 250 may be made of a substantially transparent plate of, for example, glass or polymer. Accordingly, the second display 300 may be disposed in the inner space of the second housing 220 to be visible from the outside through the second rear surface cover 250.

According to various embodiments, the input device 215 may include a microphone. In some embodiments, the input devices 215 may include a plurality of microphones disposed to detect the direction of sound. According to an embodiment, the sound output devices 227 and 228 may include speakers. According to an embodiment, the sound output devices 227 and 228 may include a call receiver 227 disposed through the fourth surface 222 of the second housing 220, and an external speaker 228 disposed through at least a portion of the second side surface member 223 of the second housing 220. In some embodiments, the input devices 215, the sound output devices 227 and 228, and the connector ports 229 may be disposed in the spaces of the first housing 210 and/or the second housing 220, and may be exposed to the external environment through one or more holes provided in the first housing 210 and/or the second housing 220. In some embodiments, the holes provided in the first housing 210 and/or the second housing 220 may be commonly used for the input device 215 and the sound output devices 227 and 228. In some embodiments, the sound output devices 227 and 228 may include a speaker that operates without holes provided in the first housing 210 and/or the second housing 220 (e.g., a piezo speaker).

According to various embodiments, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. In an embodiment, the electronic device 200 may include a flash 218 located near the second camera module 216b. According to an embodiment, the flash 218 may include, for example, a light-emitting diode or a xenon lamp. According to an embodiment, the camera modules 216a, 216b, and 225 may include one or more lenses, an image sensor, and/or an image signal processor. In some embodiments, at least one of the camera modules 216a, 216b, and 225 may include two or more lenses (e.g., wide-angle and telephoto lenses) and image sensors, and the camera modules may be disposed together on one surface of the first housing 210 and/or the second housing 220.

According to various embodiments, the sensor modules 217a, 217b, and 226 may generate electrical signals or data valuescorresponding to an internal operating state or an external environmental state of the electronic device 200. According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In some embodiments, the sensor modules 217a, 217b, and 226 may include at least one of a gesture sensor, a grip sensor, a color sensor, an infrared (IR) sensor, an illumination sensor, an ultrasonic sensor, an iris recognition sensor, or a distance detection sensor (e.g., a time-of-flight (TOF) sensor or a light detection and ranging (LiDAR) sensor).

According to various embodiments, the electronic device 200 may further include at least one of sensor modules (not illustrated) such as an air pressure sensor, a magnetic sensor, a biometric sensor, a temperature sensor, a humidity sensor, or a fingerprint recognition sensor. In some embodiments, the fingerprint recognition sensor may be disposed through at least one of the first side surface member 213 of the first housing 210 and/or the second side surface member 223 of the second housing 220.

According to various embodiments, the key input devices 219 may be disposed to be exposed to the outside through the first side surface member 213 of the first housing 210. In some embodiments, the key input devices 219 may be disposed to be exposed outside through the second side surface member 223 of the second housing 220. In some embodiments, the electronic device 200 may not include some or all of the above-mentioned key input devices 219, and a key input device 219, which is not included, may be implemented in another form, such as a soft key, on at least one display 230 or 300. As another embodiment, the key input devices 219 may be implemented using pressure sensors included in at least one display 230 or 300.

According to various embodiments, the connector ports 229 may include a connector (e.g., a USB connector or an interface connector port module (IF module)) configured to transmit/receive power and/or data to and from an external electronic device. In some embodiments, the connector ports 229 may further include a separate connector port (e.g., an ear jack hole) for performing a function to transmit/receive an audio signal together with the external electronic device or for performing a function to transmit/receive an audio signal.

According to various embodiments, at least one camera module 216a or 225 among the camera modules 216a, 216b, and 225, at least one sensor module 217a or 226 among the sensor modules 217a, 217b, and 226, and/or an indicator may be disposed to be visually exposed through the at least one display 230 or 300. For example, the at least one camera module 216a or 225, the at least one sensor module 217a or 226, and/or the indicator may be disposed in the inner space of the at least one housing 210 or 300 below the active area (display area) of the at least one display 230 or 300, and may be disposed to come into contact with the external environment through an opening perforated up to the cover member (e.g., a window layer (not illustrated) of the first display 230 and/or the second rear surface cover 250) or a transparent area. According to an embodiment, an area in which the at least one display 230 or 300 and the at least one camera module 216a or 225 face each other may be provided as a transmissive area with a predetermined transmittance as a portion of a content display area. According to an embodiment, the transmissive area may have a transmittance ranging from about 5% to about 20%. The transmissive area may include an area overlapping the effective area (e.g., a view angle area) of the at least one camera module 216a or 225 through which light imaged by an image sensor to generate an image passes. For example, the transmissive area of the display 230 or 300 may include an area having a lower pixel density than the periphery. For example, the transmissive area may replace an opening. For example, the at least one camera module 216a or 225 may include an under-display camera (UDC) or an under-panel camera (UPC). As another embodiment, some camera modules 216a and 225 or sensor modules 217a and 226 may be disposed to perform the functions thereof without being visually exposed through the displays 230 and 300. For example, the areas facing the camera modules 216a and 225 and/or the sensor modules 217a and 226 disposed under the displays 230 and 300 (e.g., a display panel) may have an under-display camera (UDC) structure, and may not require a perforated opening.

FIG. 9 is an exploded perspective view of an electronic device according to various embodiments of the disclosure.

Referring to FIG. 9, the electronic device 200 may include a first display 230 (e.g., a flexible display), a second display 300, a hinge device 400, a pair of support members 261 and 262, at least one board 270 (e.g., a printed circuit board (PCB)), a first housing 210, a second housing 220, a first rear surface cover 240, and/or a second rear surface cover 250.

According to various embodiments, the first display 230 may include a display panel 630 (e.g., a flexible display panel) and a support plate 650 disposed under the display panel 630. According to an embodiment, the first display 230 may include at least one functional layer 660 disposed under the support plate 650. According to an embodiment, the at least one functional layer 660 may include a first functional member 661 and a second functional member 662 separated based on a folding axis (e.g., the folding axis F in FIG. 7A). According to an embodiment, the at least one functional layer 660 may include at least one digitizer and/or at least one reinforcement plate.

According to various embodiments, the display panel 630 may include a first panel area 630a corresponding to a first area (e.g., the first area 230a in FIG. 7A) of the first display 230, a second panel area 630b extending from the first panel area 630a and corresponding to a second area (e.g., the second area 230b in FIG. 7A) of the first display 230, and a third panel area 630c interconnecting the first panel area 630a and the second panel area 630b and corresponding to a folding area (e.g., the folding area 230c in FIG. 7A) of the first display 230. According to an embodiment, the support plate 650 may be disposed between the display panel 630 and a pair of support members 261 and 262 and may be configured to have a material and a shape to provide a flat support structure for the first panel area 630a and the second panel area 630b and a bendable structure for supporting bendability of the third panel area 630c. According to an embodiment, the support plate 650 may be made of a conductive material (e.g., metal) or a non-conductive material (e.g., polymer or fiber reinforced plastics (FRP)).

According to various embodiments, the second display 300 may be disposed in the space between the second housing 220 and the second rear surface cover 250. According to an embodiment, the second display 300 may be disposed in the space between the second housing 220 and the second rear surface cover 250 to be visible from the outside through substantially the entire area of the second rear surface cover 250.

According to various embodiments, at least a portion of the first support member 261 may be coupled to the second support member 262 to be foldable via the hinge device 320. According to an embodiment, the electronic device 200 may include at least one wiring member 263 (e.g., a flexible printed circuit board (FPCB)) extending from at least a portion of the first support member 261 to a portion of the second support member 262 across the hinge device 320. According to an embodiment, the first support member 261 may extend from the first side surface member 213 or may be disposed in a manner of being structurally coupled with the first side surface member 213. According to an embodiment, the electronic device 200 may include a first space (e.g., the first space 2101 in FIG. 7A) provided by the first support member 261 and the first rear surface cover 240. According to an embodiment, the first housing 210 (e.g., the first housing structure) may be configured through the coupling of the first side surface member 213, the first support member 261, and the first rear surface cover 240. According to an embodiment, the second support member 262 may extend from the second side surface member 223 or may be disposed in a manner of being structurally coupled with the second side surface member 223. According to an embodiment, the electronic device 200 may include a second space (e.g., the second space 2201 in FIG. 7A) provided by the second support member 262 and the second rear surface cover 250. According to an embodiment, the second housing 220 (e.g., the second housing structure) may be configured through the coupling of the second side surface member 223, the second support member 262, and the second rear surface cover 250. According to an embodiment, at least a portion of the at least one wiring member 263 and/or the hinge device 320 may be disposed to be supported by at least a portion of the pair of support members 261 and 262. According to an embodiment, the at least one wiring member 263 may be disposed to extend from at least a portion of the first housing 210 to at least a portion of the second housing 220. According to an embodiment, the at least one wiring member 263 may be disposed to have a length in a direction (e.g., the x-axis direction) substantially perpendicular to the folding axis (e.g., the y-axis or the folding axis F of FIG. 7A).

According to various embodiments, the at least one board 270 may include a first board 271 disposed in the first space 2101 and a second board 272 disposed in the second space 2201. According to an embodiment, the first board 271 and the second board 272 may include a plurality of electronic components disposed thereon to implement various functions of the electronic device 200. According to an embodiment, the first board 271 and the second board 272 may be electrically connected to each other via at least one wiring member 263.

According to various embodiments, the electronic device 200 may include at least one battery 291 or 292. According to an embodiment, the at least one battery 291 or 292 may include a first battery 291 disposed in the first space 2101 of the first housing 210 and electrically connected to the first board 271, and a second battery disposed in the second space 2201 of the second housing 220 and electrically connected to the second board 272. According to an embodiment, the first support member 261 and the second support member 262 may further include one or more swelling holes for the first battery 291 and the second battery 292.

According to various embodiments, the first housing 210 may include a first rotation support surface 214, and the second housing 220 may include a second rotation support surface 224 corresponding to the first rotation support surface 214. According to an embodiment, the first rotation support surface 214 and the second rotation support surface 224 may each include a curved surface corresponding to (naturally connected to) the curved outer surface of the hinge housing 310. According to an embodiment, when the electronic device 200 is in the unfolded state, the first rotation support surface 214 and the second rotation support surface 224 may cover the hinge housing 310 to prevent the hinge housing 310 from being exposed to the rear surface of the electronic device 200 or to visually expose only a portion of the hinge housing 310 to the rear surface of the electronic device 200. According to an embodiment, when the electronic device 200 is in the folded state, the first rotation support surface 214 and the second rotation support surface 224 may rotate along the curved outer surface of the hinge housing 310 to visually expose at least a portion of the hinge housing 310 to the rear surface of the electronic device 200.

According to various embodiments, the electronic device 200 may include at least one antenna 276 disposed in the first space 2201. According to an embodiment, the at least one antenna 276 may be disposed on the first battery 291 and the first rear surface cover 240 in the first space 2201. According to an embodiment, the one or more antennas 276 may include, for example, a near-field communication (NFC) antenna, a wireless charging antenna, and/or a magnetic secure transmission (MST) antenna. According to an embodiment, the at least one antenna 276 may execute, for example, short-range communication with an external device or wireless transmission/reception of power required for charging. In some embodiments, an antenna structure may be configured by at least a portion of the first side surface member 213 or the second side surface member 223 and/or a portion of the first support member 261 and the second support member 262, or a combination thereof.

According to various embodiments, the electronic device 200 may further include at least one electronic component assembly 274 or 275 and/or additional support members 263 disposed in the first space 2101 and/or the second space 2201. For example, the at least one electronic component assembly may include an interface connector port assembly 274 or a speaker assembly 275.

According to various embodiments, the electronic device 200 may include a first waterproof member WP1 disposed between the functional layer 660 and the first support member 261 and a second waterproof member WP2 disposed between the functional layer 660 and the second support member 262. According to an embodiment, the first waterproof member WP1 may provide at least one first waterproof space between the functional layer 660 and the first support member 261. According to an embodiment, the at least one first waterproof space may accommodate an area corresponding to at least one electronic component (e.g., a camera module or a sensor module) disposed to be supported by the first support member 261. According to an embodiment, the second waterproof member WP2 may provide at least one second waterproof space between the functional layer 660 and the second support member 262. According to an embodiment, the at least one second waterproof space may accommodate at least a portion of the bending portion (e.g., a chip-on-panel (COP)) folded to the rear surface of the first display 230. For example, the at least one second waterproof space may be disposed to extend from the display panel 630 of the first display 230 and surround at least a portion of the bending portion that is folded toward the rear surface. Accordingly, a control circuit (e.g., a display driver IC (DDI)) and a plurality of electrical elements disposed in the bending portion may be disposed in the at least one second waterproof space, thereby being protected from external moisture and/or foreign substances.

According to various embodiments, the electronic device 200 may include a waterproof tape 241 disposed between the first rear surface cover 240 and the first housing 210. According to an embodiment, the electronic device 200 may include a bonding member 251 disposed between the second rear surface cover 250 and the second housing 220. In some embodiments, the bonding member 251 may be disposed between the second display 300 and the second housing 220. In some embodiments, the waterproof tape 241 may be replaced with the bonding member 251, and the bonding member 251 may be replaced with the waterproof tape 241.

According to various embodiments, the electronic device 200 may include one or more adhesive members 510 and 520 (e.g., the adhesive members 510 and 520 in FIG. 3) disposed between the first and second housings 210 and 220 and the first display 230 (e.g., a flexible display). According to an embodiment, the one or more adhesive members 510 and 520 may include a first adhesive member 510 disposed between the first housing 210 and the first display 230 and a second adhesive member 520 disposed between the second housing 220 and the first display 230.

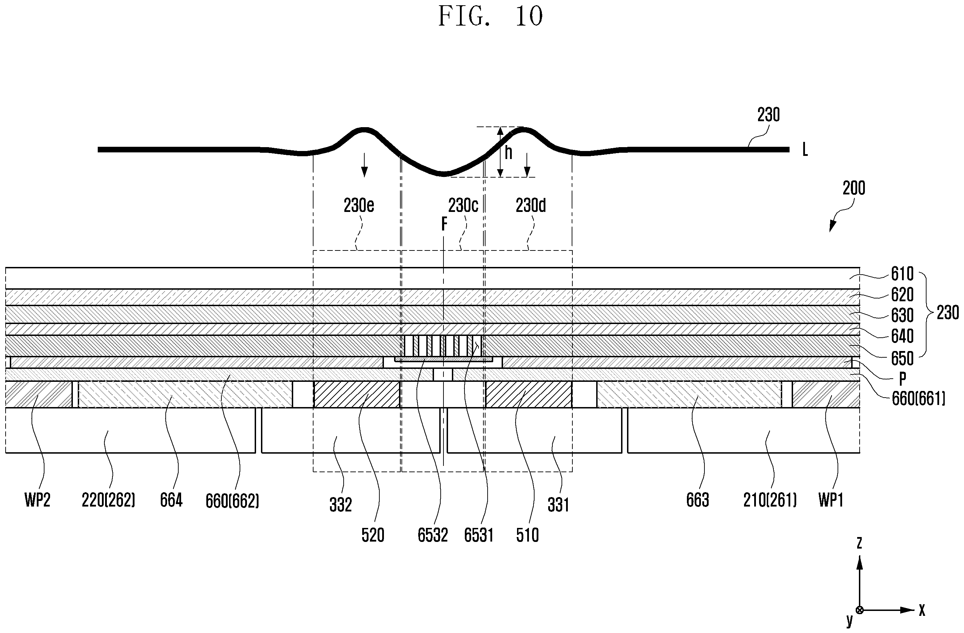

FIG. 10 is a partial cross-sectional view of an electronic device viewed along line 10-10 of FIG. 7A, according to various embodiments of the disclosure.

Referring to FIG. 10, the electronic device 200 may include a first housing 210 including a first support member 261, a second housing 220 including a second support member 262 and foldably connected to the first housing 220 via a hinge device (e.g., the hinge device 320 in FIG. 9), and a flexible display 230 disposed to be supported by the first housing 210 and the second housing 220. According to an embodiment, the first housing 210 may include a first hinge plate 331 connected to the hinge device 320, and the second housing 220 may include a second hinge plate 332 connected to the hinge device 320. Accordingly, when the electronic device 200 is in the unfolded state, the first housing 210, the first hinge plate 331, the second hinge plate 332, and the second housing 220 may form substantially the same plane, thereby supporting the flexible display 230. In some embodiments, the first housing 210 may be directly connected to the hinge device 320 without the first hinge plate 331, and the second housing 220 may be directly connected to the hinge device 320 without the second hinge plate 332.

According to various embodiments, the flexible display 230 may include a window layer 610, and a polarizing layer 620, a display panel 630, a polymer layer 640, and a support plate 650, which are sequentially disposed under the window layer 610. According to an embodiment, the support plate 650 may include a pattern 6531 including a plurality of openings formed at predetermined intervals in the folding area 230c to provide flexibility to the flexible display 230. In some embodiments, the pattern 6531 may be replaced with a plurality of recesses formed lower than the outer surface. In some embodiments, the pattern 6531 may be configured in a form in which a plurality of openings and a plurality of recesses are combined. According to an embodiment, the flexible display 230 may include a blocking member 6532 disposed in an area corresponding to the folding area 230c under the support plate 650 to block the plurality of openings of the pattern 6531. According to an embodiment, the blocking member 6532 may include a thermoplastic polyurethane (TPU) attached to the support plate 650. According to an embodiment, the electronic device may include a functional layer 660 disposed under the flexible display. In this case, the functional layer may be at least partially attached to the support plate via an adhesive P. According to an embodiment, the functional layer 660 may include a digitizer (e.g., the digitizer 661 in FIG. 4) and/or a reinforcement plate (e.g., the reinforcement plate 662 in FIG. 4).

According to various embodiments, the flexible display 230 may include crease areas 230d and 230e formed longitudinally along the folding axis F on both sides of the folding area 230c through folding and unfolding operations. According to an embodiment, the crease areas 230d and 230e may include a first crease area 230d formed at a position corresponding to at least a portion of the first housing 210 on one side of the folding area 230c, and a second crease area 230e formed at a position corresponding to at least a portion of the second housing 220 on the other side of the folding area 230c. In some embodiments, the first crease area 230d and the second crease area 230e may be formed in a portion of the folding area 230c. As illustrated, when the electronic device 200 is in the unfolded state, the folding area 230c may sag downward (e.g., in the -z-axis direction) from the flat line L of the flexible display 230, and the first crease area 230d and the second crease area 230e may protrude upward (e.g., in the z-axis direction) relative to the flat line L of the flexible display 230. Thus, the surface quality of the flexible display 230 may be deteriorated. The exemplary embodiments of the disclosure may help improve the surface quality by having an attachment structure for reducing the vertical distance h from the highest position of the crease areas 230d and 230e of the flexible display 230 to the lowest position of the folding area 230c.

According to various embodiments, the electronic device 200 may include one or more adhesive members 510 and 520 (e.g., the adhesive members 510 and 520 in FIG. 9) disposed between the flexible display 230 and the housings 210 and 220. For example, the one or more adhesive members 510 and 520 may include a first adhesive member 510 disposed between the functional layer 660 and the first housing 210 (and/or the first hinge plate 331), and a second adhesive member 520 disposed between the functional layer 660 and the second housing 220 (and/or the second hinge plate 332). According to an embodiment, the first adhesive member 510 may be disposed in a section overlapping at least the first crease area 230d when viewing the flexible display 230 from above. According to an embodiment, the second adhesive member 520 may be disposed in a section overlapping at least the second crease area 230e when the flexible display 230 is viewed from above. According to an embodiment, the first adhesive member 510 and the second adhesive member 520 may be disposed along the longitudinal direction (e.g., in the y-axis direction) of the folding axis F of the flexible display 230 at a position corresponding to at least a portion of the crease areas 230d and 230e adjacent to the folding axis F, thereby attaching the functional layer 660 and the housings 210 and 220 to each other. According to an embodiment, the electronic device 200 may include graphite 663 for heat dissipation and a waterproof member WP1 (e.g., the first waterproof member WP1 in FIG. 9) for waterproofing disposed between the functional layer 660 and the first housing 210 in at least a portion, other than the first adhesive member 510. According to an embodiment, the electronic device 200 may include a buffer member 664 for buffering and a waterproof member WP2 (e.g., the second waterproof member WP2 in FIG. 9) for waterproofing disposed between the functional layer 660 and the second housing 220 in at least a portion, other than the second adhesive member 520. According to an embodiment, the buffer member 664 may be disposed to be attached to the second housing 220 and to come into contact with the functional layer 660.

When the electronic device 200 is in the unfolded state, the attachment structure of the section corresponding to the crease areas 230d and 230e via the adhesive members 510 and 520 according to the exemplary embodiment of the disclosure may cause the crease areas 230d and 230e protruding upward relative to the flat line L of the flexible display 230 to be pulled downward (e.g., in the -z-axis direction), thereby reducing the protrusion height and helping improve the surface quality of the flexible display 230. In some embodiments, the first adhesive member 510 and the second adhesive member 520 may be integrated. In this case, the integrated adhesive members 510 and 520 may be disposed to be at least partially cross the folding area 230c.

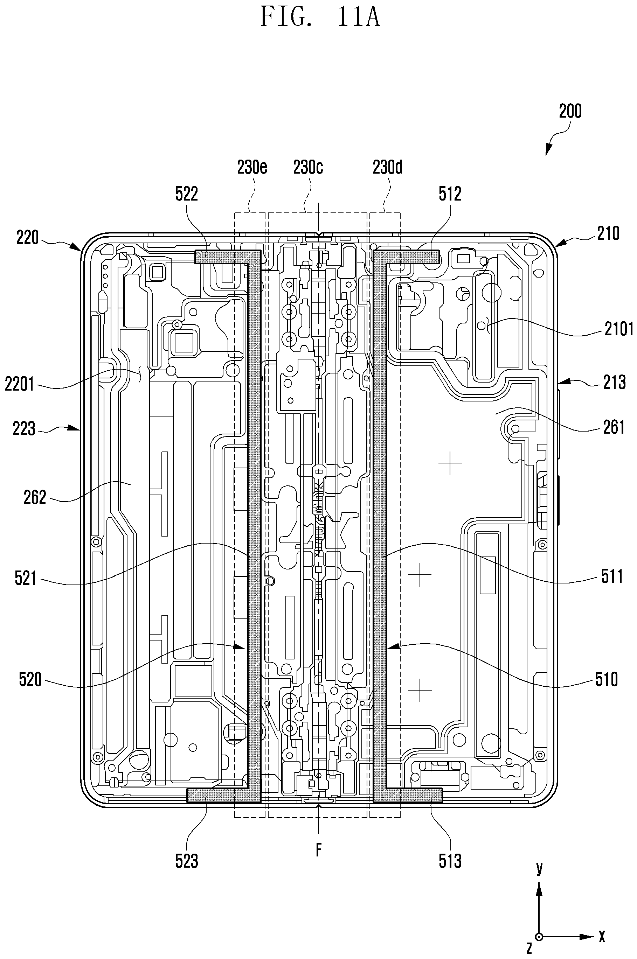

FIGS. 11A to 11H are plan views illustrating an electronic device with various arrangement structures of adhesive members according to various embodiments of the disclosure.

The electronic device 200 is illustrated in FIGS. 11A to 11H in a state in which a flexible display 230 is omitted.

Referring to FIG. 6A, the electronic device 200 may include a first housing 210 including a first support member 261, a second housing 220 including a second support member 262 and foldably connected to the first housing 220 via a hinge device (e.g., the hinge device 320 in FIG. 9), and a flexible display (e.g., the flexible display 230 in FIG. 10) disposed to be supported by the first housing 210 and the second housing 220. According to an embodiment, the electronic device 200 may display an image in portions of the above-described flexible display 230 corresponding to the folding area 230c, the first crease area 230d, and the second crease area 230e.

According to various embodiments, the electronic device 200 may include a first adhesive member 510 (e.g., the first adhesive member 510 in FIG. 5) disposed on the first support member 261 of the first housing 210 and a second adhesive member 520 (e.g., the second adhesive member 520 in FIG. 5) disposed on the second support member 262 of the second housing 220. According to an embodiment, the first adhesive member 510 may include a first portion 511 overlapping the first crease area 230d when viewing the flexible display 230 from above, a second portion 512 extending from one end of the first portion 511 to the first space 2101, and a third portion 513 extending from the other end of the first portion 511 to the first space 2101. According to an embodiment, the second adhesive member 520 may be disposed in a symmetrical structure with the first adhesive member 510. According to an embodiment, the second adhesive member 520 may include a fourth portion 521 overlapping the second crease area 230e when viewing the flexible display 230 from above, a fifth portion 522 extending from one end of the fourth portion 521 to the second space 2201, and a sixth portion 523 extending from the other end of the fourth portion 521 to the second space 2201. According to an embodiment, the first crease area 230d and the second crease area 230e of the flexible display 230 may be pulled downward (e.g., in the -z-axis direction) in the unfolded state by the first portion 511 of the first adhesive member 510 and the fourth portion 521 of the second adhesive member 520 disposed at positions overlapping the first and second crease areas 130d and 130e, thereby helping improve the surface quality of the flexible display 230. According to an embodiment, the second portion 512, the third portion 513, the fifth portion 522, and the sixth portion 523 may help ensure stable operation of the electronic device 200 by expanding the bonding area between the flexible display 230 and the housings 210 and 220.

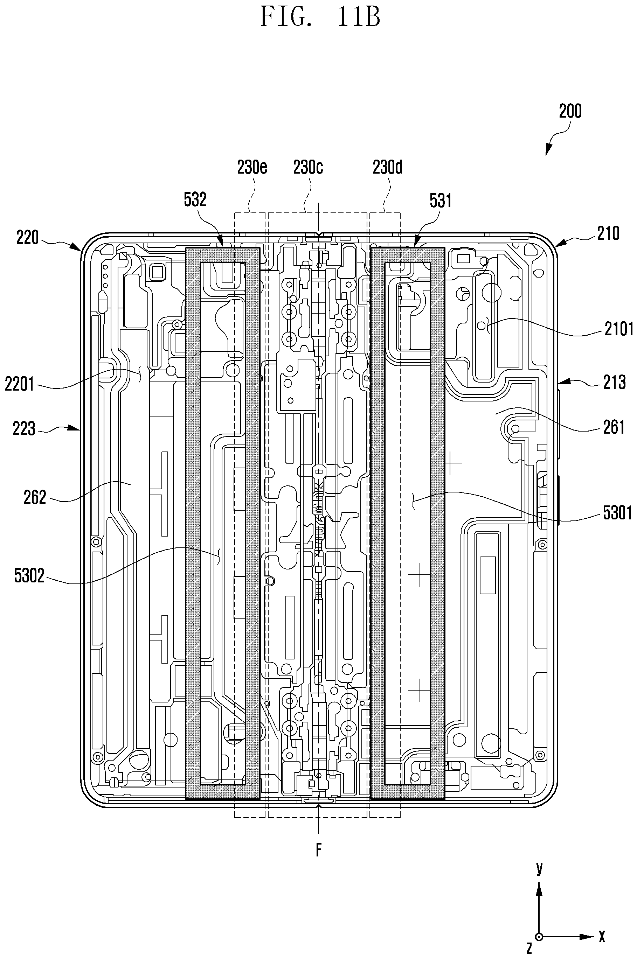

Hereinafter, in describing the electronic device 200 of FIGS. 11B to 11H, the components that are substantially the same as those of the electronic device 200 of FIG. 11A may be assigned with the same reference numerals, and a detailed description thereof may be omitted. In addition, as illustrated in FIGS. 11B to 11H, adhesive members 531, 532, 533, 534, 535, 536, 537, 538, 539, 540, 541, and 542 may be attached in substantially the same manner as FIGS. 6B to 6H and may have various shapes that are modified according to the arrangement design of various structures (e.g., graphite, waterproof members, or one or more electronic components) disposed in the inner spaces 2101 and 2201 of the electronic device 200.

Referring to FIG. 11B, the electronic device 200 may include a first adhesive member 531 disposed at a position at least partially corresponding to the first crease area 230d of the flexible display 230 and a second adhesive member 532 disposed at a position at least partially corresponding to the second crease area 230e. According to an embodiment, the first adhesive member 531 may be formed in a closed loop shape to have a first sealed space 5301, and the second adhesive member 532 may be formed in a closed loop shape to have a second sealed space 5302. In this case, the first sealed space 5301 and the second sealed space 5302 may be utilized as waterproof spaces for one or more electronic components.

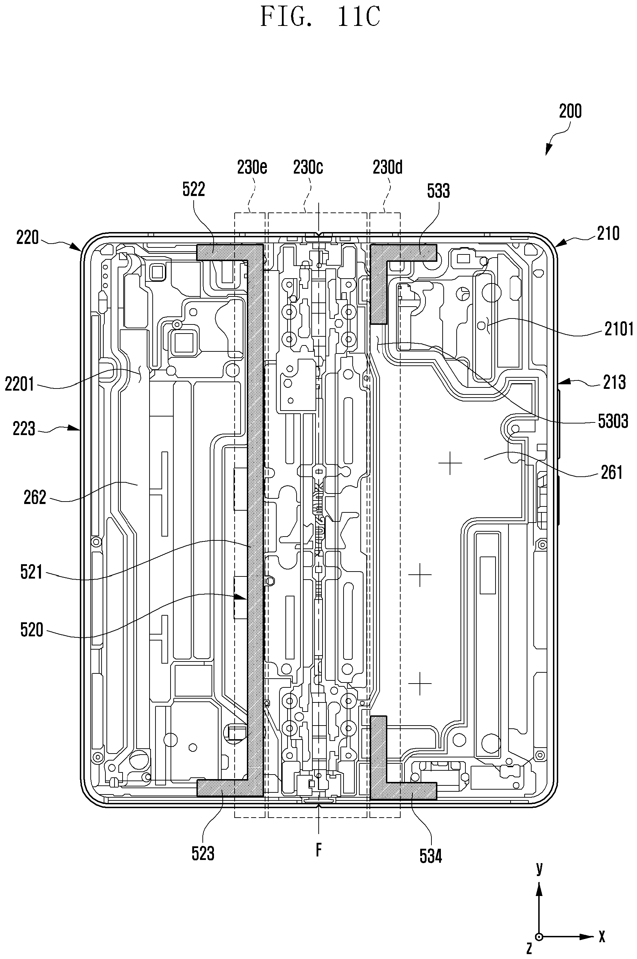

Referring to FIG. 11C, the electronic device 200 may include a first adhesive member 533 and a second adhesive member 534 disposed at a position at least partially corresponding to at least a first crease area 230d of the flexible display 230. According to an embodiment, the first adhesive member 533 and the second adhesive member 534 may be disposed in an area corresponding to the first crease area 230d to have a first separation space 5303 therebetween. According to an embodiment, the electronic device 200 may include a third adhesive member 520 formed in a shape substantially identical to the second adhesive member 520 of FIG. 11A and disposed at a position corresponding to the second crease area 230e. According to an embodiment, the first separation space 5303 may be utilized as an expanded attachment space for a heat dissipation member such as graphite (e.g., the graphite 663 of FIG. 10) disposed in the first housing 210.

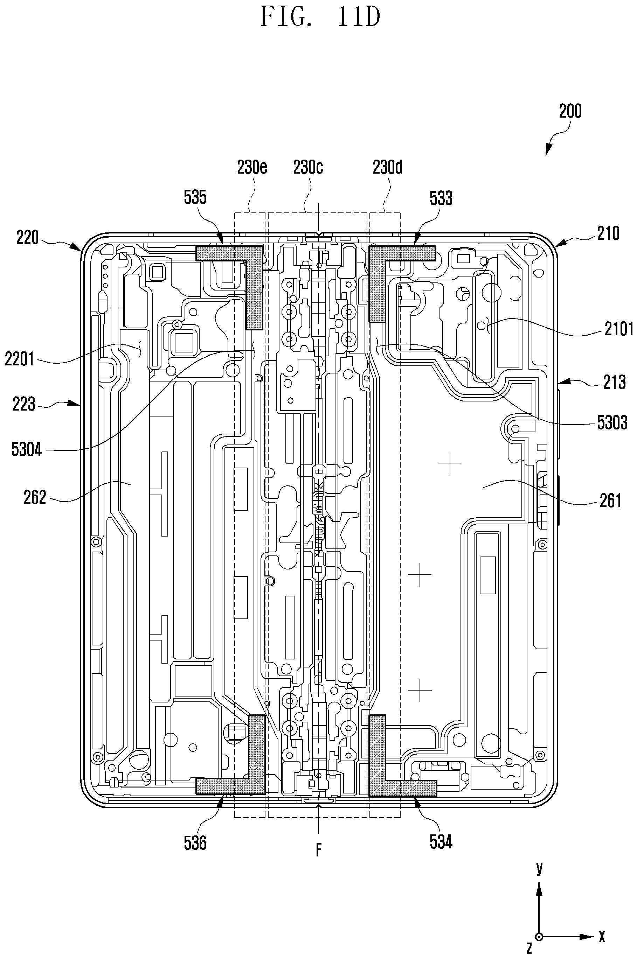

Referring to FIG. 11D, the electronic device 200 may include a first adhesive member 533 and a second adhesive member 534 formed in substantially the same shape as the first adhesive member 533 and the second adhesive member 534 of FIG. 11C, and disposed to have a first separation space 5303 at a position corresponding to the first crease area 230d. According to an embodiment, the electronic device 200 may include a third adhesive member 535 and a fourth adhesive member 536 substantially symmetrically disposed with respect to the first adhesive member 533 and the second adhesive member 534 in an area corresponding to the second crease area 230e. According to an embodiment, the third adhesive member 535 and the fourth adhesive member 536 may be disposed in an area corresponding to the second crease area 230e to have a second separation space 5304. According to an embodiment, the first separation space 5303 may be utilized as an expanded attachment space for a heat dissipation member such as graphite (e.g., the graphite 663 of FIG. 10) disposed in the first housing 210. According to an embodiment, the second separation space 5304 may be utilized as an expanded attachment space for a buffer member (e.g., the buffer member 664 in FIG. 10) disposed in the second housing 220.

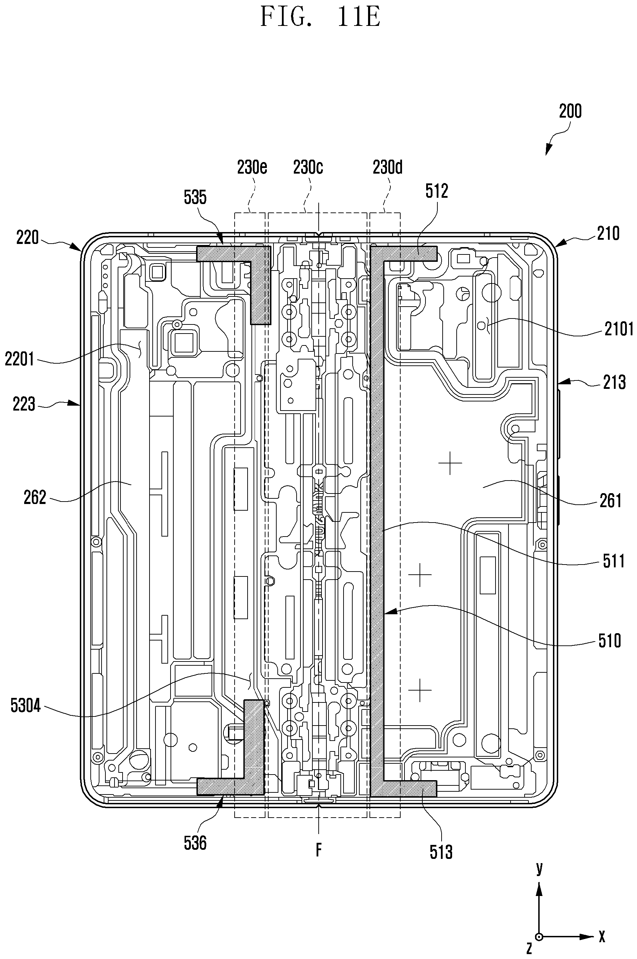

Referring to FIG. 11E, the electronic device may include a first adhesive member 520 formed in substantially the same shape as the first adhesive member 510 of FIG. 11A and disposed to at least partially overlap the first crease area 230d. According to an embodiment, the electronic device may include a second adhesive member 535 and a third adhesive member 536 formed in substantially the same shape as the third adhesive member 535 and the fourth adhesive member 536 of FIG. 11D, and disposed to have a separation space 5304 at a position corresponding to the second crease area 230e.

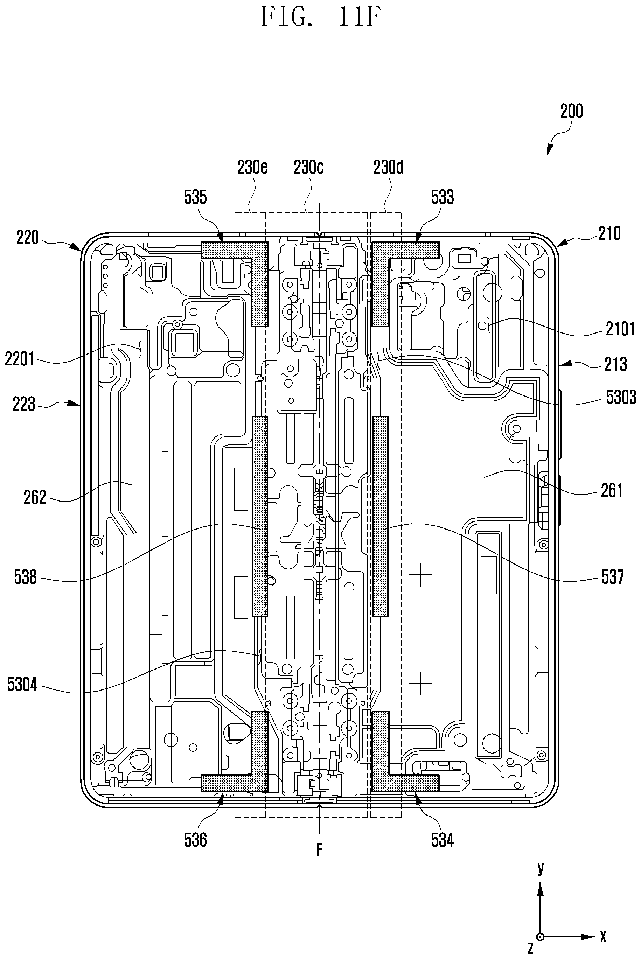

Referring to FIG. 11F, the electronic device 200 may include a fifth adhesive member 537 disposed in the first separation space 5303 between the first adhesive member 533 and the second adhesive member 534 of FIG. 11D in an area corresponding to the first crease area 230d. According to an embodiment, the electronic device 200 may include a sixth adhesive member 538 disposed in the second separation space 5304 between the third adhesive member 535 and the fourth adhesive member 536 of FIG. 11D in an area corresponding to the second crease area 230e.

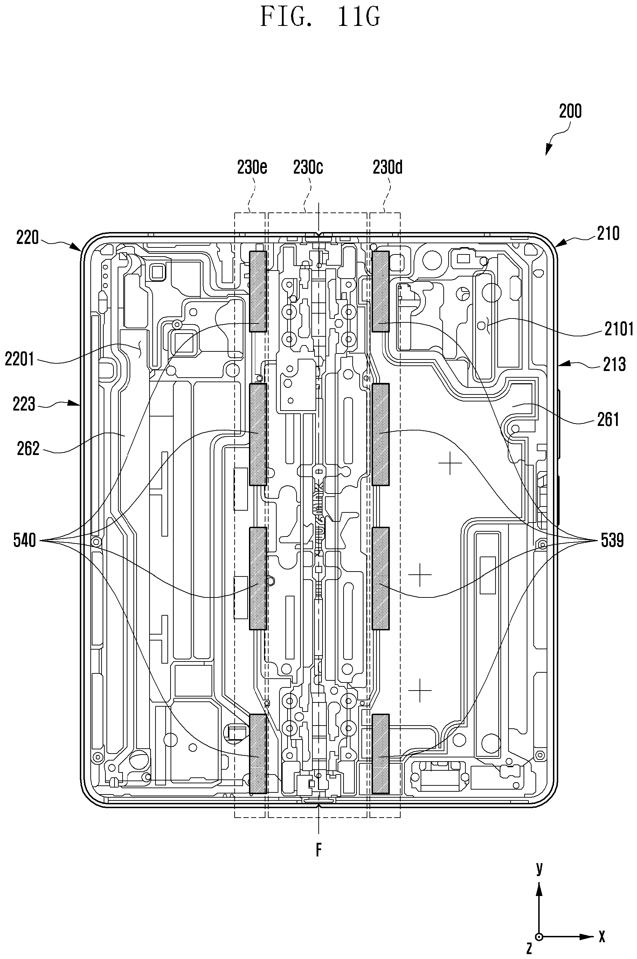

Referring to FIG. 11G, the electronic device 200 may include a plurality of first adhesive members 539 disposed at a predetermined interval in an area corresponding to the first crease area 230d and a plurality of second adhesive members 540 disposed at a predetermined interval in an area corresponding to the second crease area 230e.

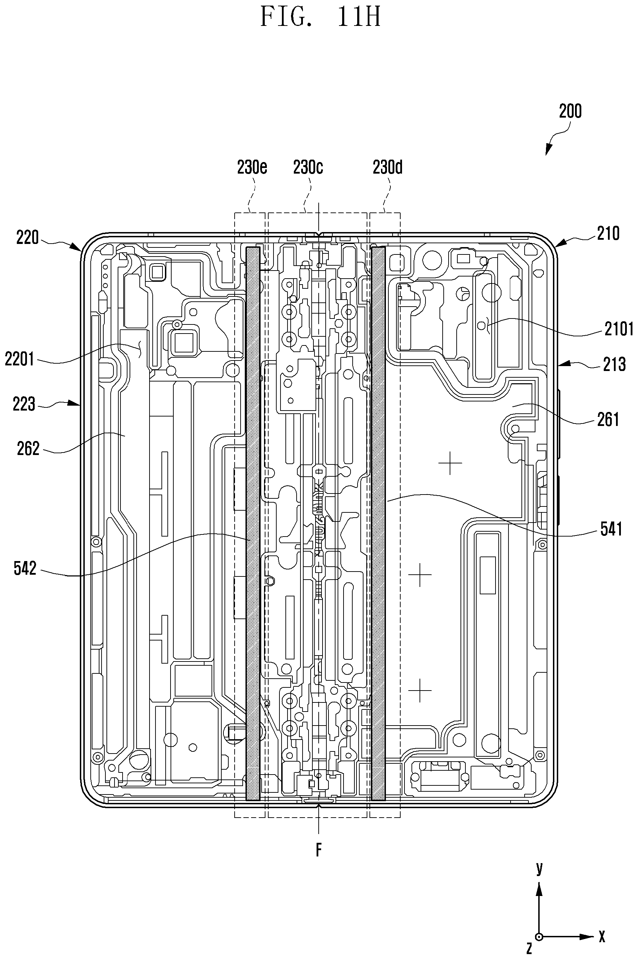

Referring to FIG. 11H, the electronic device 200 may also include a first adhesive member 541 disposed only in an area corresponding to the first crease area 230d and a second adhesive member 542 disposed only in an area corresponding to the second crease area 230e.

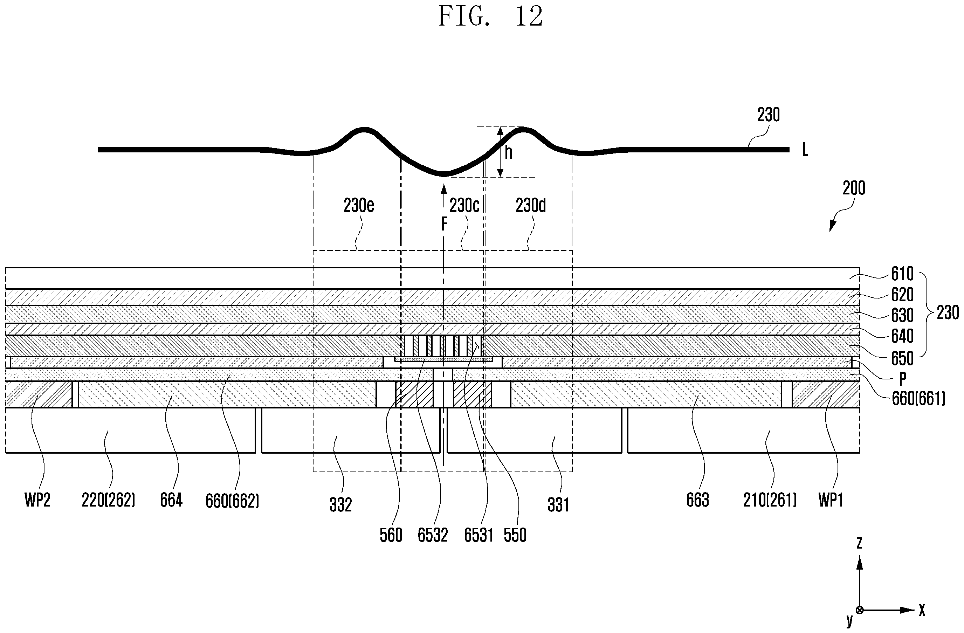

FIG. 12 is a partial cross-sectional view of an electronic device including cushion members according to various embodiments of the disclosure.

In describing the electronic device 200 of FIG. 12, substantially the same components as those of the electronic device 200 of FIG. 10 are denoted by the same reference numerals, and a detailed description thereof may be omitted.

Referring to FIG. 12, the electronic device 200 may include a first cushion member 550 disposed between the functional layer 660 and the first housing 210 and a second cushion member 560 disposed between the functional layer 660 and the second housing 220. According to an embodiment, the first cushion member 550 and the second cushion member 560 may be disposed in an area that overlaps at least the folding area 230c when viewing the flexible display 230 from above. According to an embodiment, the first cushion member 550 and the second cushion member 560 may support upward (e.g., in z-axis direction) the folding area 230c of the flexible display 230 which sags downward (e.g., in the -z-axis direction) when the electronic device 200 in the unfolded state, thereby reducing the vertical distance h from the uppermost end of the crease areas 230d and 230e to the lowermost end of the folding area 230c and helping improve the surface quality of the flexible display 230.

According to various embodiments, the first cushion member 550 and the second cushion member 560 may be disposed to be attached to the first housing 210 and the second housing 220 and not to be attached to the functional layer 660. For example, the first cushion member 550 and the second cushion member 560 may be disposed to be in contact with or close to the functional layer 660. According to an embodiment, the first cushion member 550 and the second cushion member 560 may be made of a material having a higher compression force deflection (CFD) property than the members disposed therearound on the same layer (e.g., the heat dissipation member 663, the buffer member 664, and/or the waterproof members WP1 and WP2). For example, the first and second cushion members 550 and 560 made of a high-repulsive material having a higher CFD property than the surroundings may support the folding part (230c) in an upward direction (e.g., in the z-axis direction) when the electronic device 200 is in the unfolded state, thereby reducing the sagging of the folding portion 230c downward (e.g., in the -z-axis direction). In some embodiments, the first and second cushion members 550 and 560 may be formed to have the same or smaller thickness than the members (e.g., the heat dissipation member 663, the buffer member 664, and/or the waterproof members WP1 and WP2) disposed therearound on the same layer. In some embodiments, the first and second cushion members 550 and 560 may be made of a high-repulsive polyurethane material having a CFD of 0.25 or greater. For example, the CFD of 0.25 may refer to a compressive repulsive force generated when the material is compressed by 25%, and the force may be represented as a value per unit area, measured in MPa.

According to various embodiments, the first and second cushion members 510 and 520 may be disposed at positions corresponding to at least a portion of the folding areas 230c along the longitudinal direction of the folding axis F of the flexible display 230 (e.g., the y-axis direction), thereby causing the top surfaces thereof to be in contact with or close to the functional layer 660 and the rear surfaces thereof to be attached to the housings 210 and 220 (or the hinge plates 331 and 332). According to an embodiment, the electronic device 200 may include graphite 663 for heat dissipation and a waterproof member WP1 (e.g., the first waterproof member 484 in FIG. 9) for waterproofing disposed between the functional layer 660 and the first housing 210 in at least a portion, other than the first cushion member 550. According to an embodiment, the electronic device 200 may include a buffer member 664 for buffering and a waterproof member WP2 (e.g., the second waterproof memberWP21 in FIG. 9) for waterproofing disposed between the functional layer 660 and the second housing 220 in at least a portion, other than the second cushion member 560. According to an embodiment, the buffer member 664 may be disposed to be attached to the second housing 220 and to come into contact with the functional layer 660 rather than being attached to the same.

When the electronic device 200 is in the unfolded state, the attachment structure of the section corresponding to the folding area 230c via the cushion members 550 and 560 according to the exemplary embodiment of the disclosure may cause the folding area 230c sagging downward relative to the flat line L of the flexible display 230 to be supported upward (e.g., in the z-axis direction), thereby reducing the degree of sagging and helping improve the surface quality of the flexible display 230. In some embodiments, the first and second cushion members 550 and 560 may be integrated. In this case, the integrated cushion members 550 and 560 may be disposed to at least partially cross the folding area 230c.

In some embodiments, the first and second cushion members 550 and 560 may be disposed in substantially the same manner between the functional layer 460 and the housings 110 and 120 in a portion corresponding to the folding area 130c of the flexible display 400 in the electronic device 100 of FIG. 5.

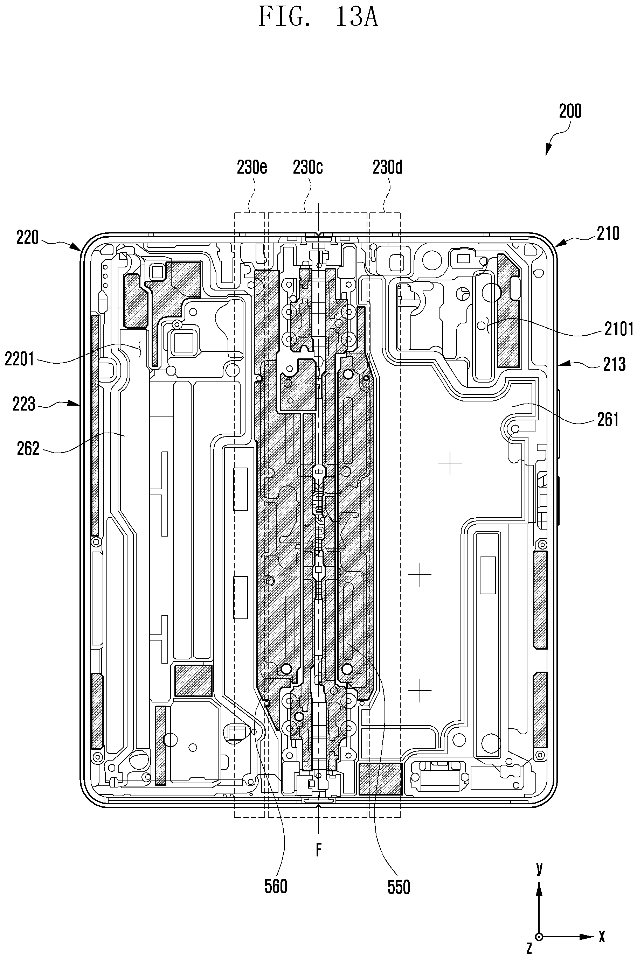

FIGS. 13A to 13B are plan views illustrating an electronic device with various arrangement structures of cushion members according to various embodiments of the disclosure.

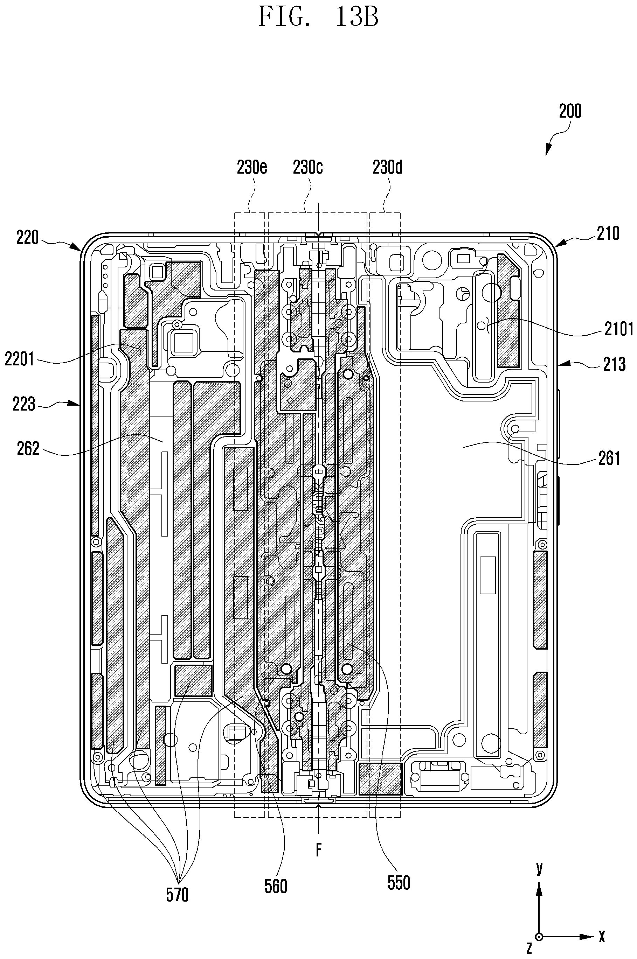

In describing the electronic device of FIGS. 13A and 13B, the components that are substantially the same as those of the electronic device of FIG. 11A are assigned with the same reference numerals, and a detailed description thereof may be omitted.

Referring to FIG. 13A, the electronic device 200 may include a first cushion member 550 and a second cushion member 560 attached to the first housing 210 and the second housing 220, respectively, at positions corresponding to the folding area 230c of the flexible display 230. According to an embodiment, the first cushion member 550 may be attached to the first support member 261 of the first housing 210 at a position corresponding to the folding area 230c of the flexible display 230. According to an embodiment, the second cushion member 560 may be attached to the second support member 262 of the second housing 220 at a position corresponding to the folding area 230c of the flexible display 230. According to an embodiment, the first cushion member 550 and the second cushion member 560 may be disposed in the folding area 230c in the longitudinal direction (e.g., the y-axis direction) along the folding axis F of the flexible display 230, thereby supporting the folding area 230c that sags downward (e.g., in the -z-axis direction) in the unfolded state, thereby helping improve the surface quality of the flexible display 230.

Referring to FIG. 13B, the electronic device 200 may include a plurality of additional cushion members 570 disposed in an area other than the folding area 230c of the flexible display 230. According to an embodiment, the plurality of additional cushion members 570 may be disposed in at least a portion of the second support member 262 corresponding to the second area 230b (e.g., a flat surface portion) of the flexible display 230. According to an embodiment, the plurality of additional cushion members 570 may also be attached to the second support member 262 of the second housing 220 in a similar manner to the first and second cushion members 550 and 560 and may be disposed to be in contact with or close to the functional layer 660. According to an embodiment, the plurality of additional cushion members 570 may also be made of a high-repulsive polyurethane material having a CFD value of 0.25 or higher, which has a higher CFD property than the members (e.g., graphite or buffer members) disposed therearound on the same layer. According to an embodiment, the plurality of additional cushion members 570 and the first and second cushion members 550 and 560 may be disposed to have an area ranging from about 18% to about 40% of the total area of the electronic device 200. For example, the plurality of additional cushion members and the first and second cushion members may have a greater repulsive force against compression than general materials (e.g., sponge with a CFD of 0.09) and perform buffering function without being immediately compressed by an impact (e.g., pen drop) applied to the exterior of the flexible display 230, thereby helping improve the durability of the flexible display 230. In an embodiment, the plurality of additional cushion members 570 and/or first and second cushion members 550 and 560 may be attached to the second housing 220 between the second housing 220 and the flexible display 230, and may have a thickness that forms a predetermined gap with the flexible display 230. The predetermined gap may help reduce adhesion failure due to the repulsive force of the cushion members 550, 560, and 570 against compression during the assembly of the flexible display 230. In such a case, the thicknesses of the plurality of additional cushion members 570 and/or the first and second cushion members 550 and 560 may be about 160 µm. In one embodiment, the predetermined gap may be about 30 µm. In some embodiments, the plurality of additional cushion members 570 may be disposed in at least a portion of the first support member 261 corresponding to the first area 230a (e.g., a flat surface portion) of the flexible display 230. In some embodiments, the plurality of additional cushion members 570 may be disposed between the first housing 110 and the functional layer 460 and/or between the second housing 120 and the functional layer 460 of the electronic device 100 of FIG. 5.

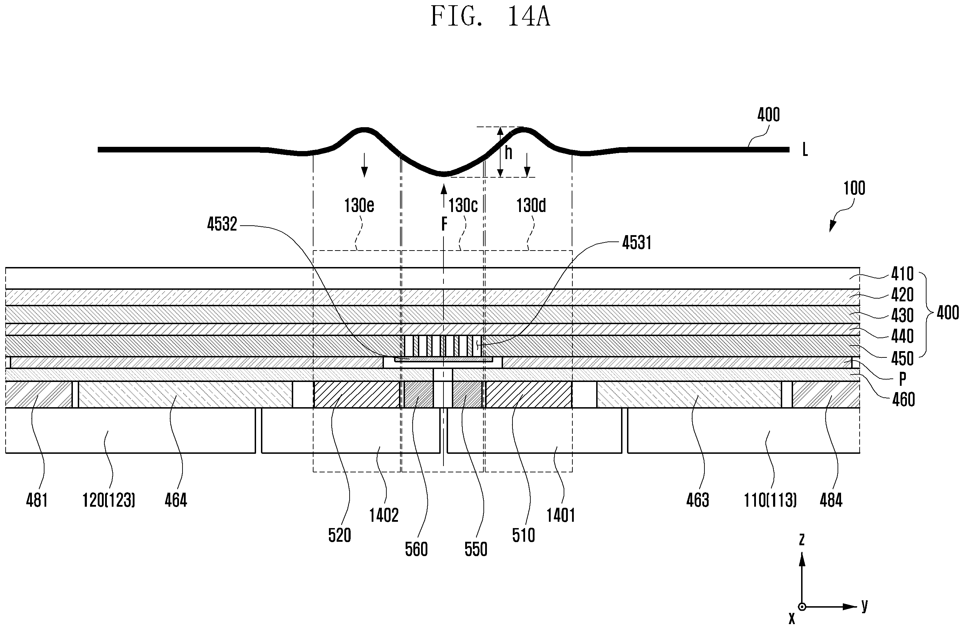

FIGS. 14A to 14C are partial cross-sectional views of an electronic device with adhesive members and cushion members according to various embodiments of the disclosure.

In describing the electronic device 100 in FIGS. 14A to 14C, the components that are substantially the same as those of the electronic device 100 of FIG. 5 may be assigned with the same reference numerals, and a detailed description thereof may be omitted.

Referring to FIG. 14A, the electronic device 100 may include a first adhesive member 510 disposed between the functional layer 460 and the first housing 110, at a position at least correspondingto the first crease area 130d of the flexible display 400, and a second adhesive member 520 disposed between the functional layer 460 and the second housing 120, at a position at least correspondingto the second crease area 130e of the flexible display 400. According to an embodiment, the electronic device 100 may include a first cushion member 550 disposed between the functional layer 460 and the first housing 110, at a position at least corresponding to the folding area 130c of the flexible display 400, and a second cushion member 560 disposed between the functional layer 460 and the second housing 120, at a position at least corresponding to the folding area 130c of the flexible display 400. According to an embodiment, the first and second adhesive members 510 and 520 and the first and second cushion members 550 and 560 may be disposed on the same layer. According to an embodiment, the electronic device 100 may further include other members (e.g., graphite 463 or the buffer member 464) disposed on the same layer as the layer on which the first and second adhesive members 510 and 520 and the first and second cushion members 550 and 560 are disposed.

According to various embodiments, since the first and second adhesive members 510 and 520 are attached to the first and second housings 110 and 120 and the functional layer 460 at positions corresponding to at least the first and second crease areas 130d and 130e of the flexible display 400, in the unfolded state, the degree of protrusion of the crease areas 130d and 130e may be reduced by a force that pulls the first and second crease areas 130d and 130e downward (e.g., in the -z-axis direction), thereby helping improve the surface quality of the flexible display 400. According to an embodiment, since the first and second cushion members 550 and 560 are attached to the first and second housings 110 and 120 at positions at least corresponding to the folding area 130c of the flexible display 400 and support the functional layer 460, in the unfolded state, in the unfolded state, the first and second cushion members 550 and 560 may support the folding area 130c upward (e.g., in the z-axis direction) to reduce the degree of sagging of the folding area 130c, thereby helping improve the surface quality of the flexible display 400. In some embodiments, the first and second cushion members 550 and 560 may be formed to have a thickness smaller than the thickness of the peripheral members 463 and 464 considering the compression tolerance of the peripheral members (e.g., the graphite 463 and/or the buffer members 464) when the flexible display 400 is attached to the first and second housings 110 and 120.

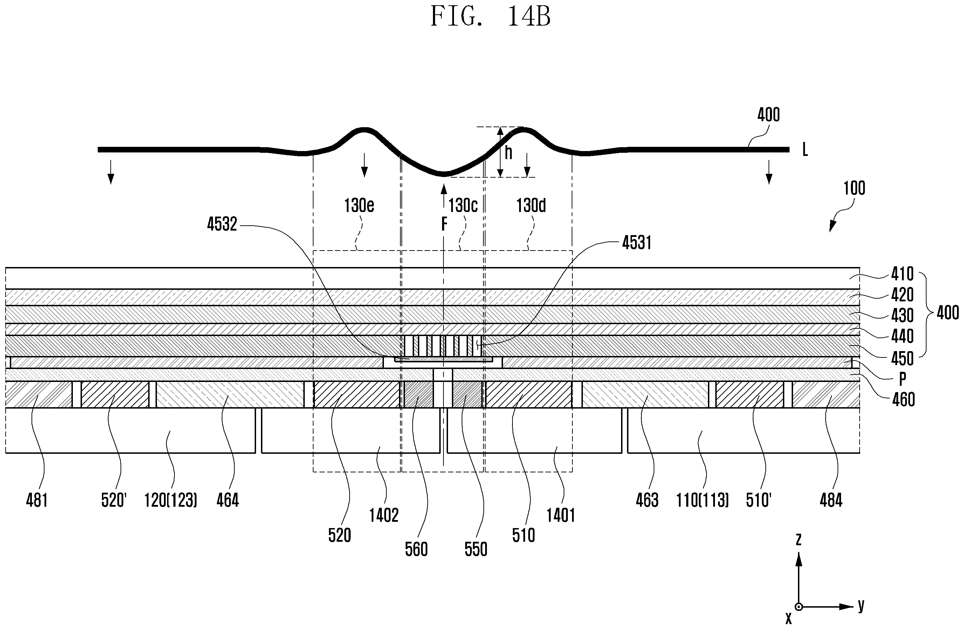

Referring to FIG. 14B, the electronic device 100 may include, in the configuration of FIG. 14A, a third adhesive member 510' disposed between the first housing 110 and the functional layer 460, at a position corresponding to an area (e.g., the first area 130a in FIG. 1B) other than the first crease area 130d, and a fourth adhesive member 520' disposed between the second housing 120 and the functional layer 460, at a position corresponding to an area other than the second crease area 130e (e.g., the second area 130b in FIG. 1B). According to an embodiment, the third adhesive member 510' and the fourth adhesive member 520' may assist in reducing the degree of protrusion of the first crease area 130d and the second crease area 130e in the unfolded state.

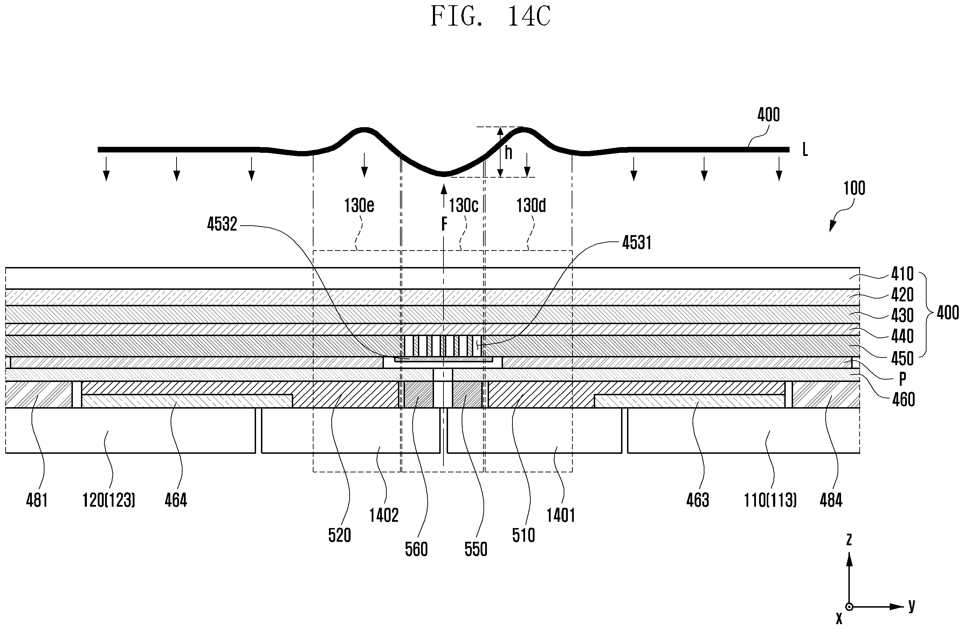

Referring to FIG. 14C, in the configuration of the electronic device 100 of FIG. 14A, at least a portion of the first adhesive member 510 and the second adhesive member 520 may be disposed to overlap at least a portion of the peripheral members (e.g., the graphite 463 or the buffer member 464) disposed on the same layer. For example, the total thickness of the area where the first and second adhesive members 510 and 520 and the peripheral members 463 and 464 overlap may be substantially the same as the thickness of the first and second adhesive members 510 and 520 that do not overlap.

In some embodiments, it is obvious that a mixed arrangement structure of the first and second adhesive members 510 and 520 and the first and second cushion members 550 and 560 is applicable to the electronic device 200 of FIG. 10.

FIG. 15 is a partial cross-sectional view of an electronic device according to various embodiments of the disclosure.

In describing the electronic device of FIG. 15, the same reference numerals are assigned to components substantially the same as those of the electronic device of FIG. 5, and a detailed description thereof may be omitted.

Referring to FIG. 15, the electronic device may include a flexible display 400 that is disposed to be supported by the first housing 110 and the second housing 120. According to an embodiment, the flexible display 400 may include a display panel 430, a polarizing layer 420, laminated on the top surface of the display panel 430, and a window layer 410 laminated on the polarizing layer 420. According to an embodiment, the flexible display 400 may include a polymer layer 440, a support plate 450, and a functional layer 460 which are laminated on the rear surface of the display panel 430.

According to various embodiments, the window layer 410 may include a first layer 411 and a second layer 412 that are sequentially laminated. According to an embodiment, the first layer 411 may be made of a polymer (e.g., polyethylene terephthalate (PET), polyimide (PI), or thermoplastic polyurethane (TPU)). According to an embodiment, the second layer 412 may be made of glass. According to an embodiment, the second layer 412 may include ultra-thin glass (UTG). In some embodiments, the flexible display 400 may further include a coating layer formed as a part of the window layer 410 and disposed on top of the first layer 411. According to an embodiment, the first layer 411 may be laminated to be attached to the second layer 412 by a first adhesive P1 (e.g., an adhesive member) having a first thickness t1. According to an embodiment, the second layer 412 may be laminated to be attached to the polarizing layer 420 or the display panel 430 by a second adhesive P2 (e.g., an adhesive member) having a second thickness t2. According to an embodiment, the first adhesive P1 and the second adhesive P2 may be made of the same material. In some embodiments, the first adhesive P1 and the second adhesive P2 may contain adhesives having different elastic moduli.

According to various embodiments, when the first thickness t1 of the first adhesive P1 included in the window layer 410 increases, the flexible display 400 may be improved in durability, but may be vulnerable to indentations such as pen drops or fingernail marks. According to exemplary embodiments of the disclosure, while the total thickness of the adhesives P1 and P2 is maintained at a thickness for enhancing durability, the second thickness t2 of the second adhesive P2 disposed under the second layer 412 formed of glass may be greater than the first thickness t1 of the first adhesive P1 to be relatively less affected by indentations in the window layer 410. The laminated structure of the window layer 411 in which the adhesives P1 and P2 have different thicknesses may help improve the durability of the flexible display 400 and may be advantageous in preventing indentations.

In some embodiments, it is apparent that the laminated structure of this window layer 410 is applicable to the window layer 610 of FIG. 10.

According to various embodiments, an electronic device may include a first housing 110, a second housing 120 coupled to the first housing 110 to be foldable around a folding axis F via a hinge device 140. The electronic device may include a flexible display 400 disposed to be supported by the first housing 110 and the second housing 120 and including a folding area 130c. The flexible display may include a window layer 410, a display panel 430 disposed under the window layer, a support plate 450 disposed under the display panel and including a pattern 4531 formed at a position at least corresponding to the folding area, and at least one functional layer 460 disposed under the support plate. The electronic device may include a first adhesive member 510 disposed between the first housing 110 and the at least one functional layer 460 at a position adjacent to one side of the folding area to have a length in a direction parallel to the folding axis. The electronic device may include a second adhesive member 520 disposed between the second housing 120 and the at least one functional layer 460 at a position at least adjacent to the other side of the folding area to have a length in a direction parallel to the folding axis.

According to various embodiments, the first adhesive member 150 may be attached to the first housing and the functional layer, and the second adhesive member 250 may be attached to the second housing and the functional layer.

According to various embodiments, the functional layer may include a first reinforcement plate 4261 corresponding to at least a portion of the first housing, and a second reinforcement plate 4622 spaced apart from the first reinforcement plate and corresponding to at least a portion of the second housing.

According to various embodiments, the functional layer may include a first digitizer 4611 corresponding to at least a portion of the first housing, and a second digitizer 4622 electrically connected to the first digitizer and corresponding to at least a portion of the second housing.

According to various embodiments, the pattern 4531 may include a plurality of openings and/or a plurality of recesses formed in an area corresponding to the folding area.

According to various embodiments, the first adhesive member 510 and/or the second adhesive member 520 may include at least one of double-sided tape, waterproof tape, an optical clear adhesive (OCA), a pressure-sensitive adhesive (PSA), a thermally reactive adhesive, or a general adhesive.

According to various embodiments, the electronic device may include a first cushion member 550 disposed between the first housing and the at least one functional layer at a position overlapping at least the folding area when viewed from above the flexible display, and a second cushion member 560 disposed between the second housing and the at least one functional layer at a position overlapping at least the folding area when viewed from above the flexible display.

According to various embodiments, the first cushion member 550 and the second cushion member 560 may be made of a material having a higher compression force deflection (CFD) property than one or more peripheral members 463 and 464 disposed on the same layer.

According to various embodiments, the first cushion member 550 and the second cushion member 560 may be made of a material having the CFD property of at least 0.25.

According to various embodiments, the first cushion member 550 and the second cushion member 560 may be attached to the first housing 110 and the second housing 120, respectively, excluding the functional layer.

According to various embodiments, the one or more peripheral members 463 and 464 may include at least one of a buffer member, a heat dissipation member, or a waterproof member.

According to various embodiments, the first cushion member 550 and the second cushion member 560 may have a thickness equal to or smaller than that of the one or more peripheral members.

According to various embodiments, the window layer 410 may include a first layer 411 made of a polymer material, and a second layer 412 disposed under the first layer and formed of a glass material, and an adhesive attaching the second layer to the display panel has a thickness t2 greater than a thickness t1 of an adhesive attaching the second layer to the first layer.

According to various embodiments, an electronic device may include a first housing 210, and a second housing 220 coupled to the first housing 210 to be foldable around a folding axis F via a hinge device 320. The electronic device may include a flexible display 230 disposed to be supported by the first housing 110 and the second housing 120 and including a folding area 230c. The flexible display may include a window layer 610, a display panel 630 disposed under the window layer, a support plate 650 disposed under the display panel and including a pattern 6531 formed at a position at least corresponding to the folding area, and at least one functional layer 660 disposed under the support plate 650. The electronic device may include a first cushion member 550 disposed between the first housing 210 and the at least one functional layer 660 at a position overlapping at least the folding area 230c when viewed from above the flexible display 230. The electronic device may include a second cushion member 560 disposed between the second housing 220 and the at least one functional layer 660 at a position overlapping at least the folding area 230c when viewed from above the flexible display 230.

According to various embodiments, the first cushion member 550 and the second cushion member 560 may be disposed to have a length in a direction parallel to the folding axis F.

According to various embodiments, the first cushion member 550 and the second cushion member 560 may be made of a material having a higher compression force deflection (CFD) property than one or more peripheral members 463 and 464 disposed on the same layer.

According to various embodiments, the first cushion member 550 and the second cushion member 560 may be made of a material having the CFD property of at least 0.25.

According to various embodiments, the one or more peripheral members 462 and 464 may include at least one of a buffer member, a heat dissipation member, or a waterproof member.

According to various embodiments, the first cushion member 550 and the second cushion member 560 may have a thickness equal to or smaller than that of the one or more peripheral members.

According to various embodiments, the electronic device may include a first adhesive member 510 disposed between the first housing and the at least one functional layer at a position at least adjacent to one side of the folding area to have a length in a direction parallel to the folding axis, and a second adhesive member 520 disposed between the second housing and the at least one functional layer at a position at least adjacent to the other side of the folding area to have a length in a direction parallel to the folding axis.

The embodiments of the disclosure disclosed in this specification and drawings are provided merely to propose specific examples in order to easily describe the technical features according to the embodiments of the disclosure and to help understanding of the embodiments of the disclosure, and are not intended to limit the scope of the embodiments of the disclosure. Accordingly, the scope of various embodiments of the disclosure is to be construed as including all changes or modifications derived based on the technical idea of the various embodiments of the disclosure in addition to the embodiments disclosed herein.

## Claims

1. An electronic device comprising:
a first housing (110);
a second housing (120) coupled to the first housing (110) to be foldable around a folding axis (F) via a hinge device (140);
a flexible display (400) disposed to be supported by the first housing (110) and the second housing (120), the flexible display comprising a folding area (130c), the flexible display comprising
a window layer (410),
a display panel (430) disposed under the window layer,
a support plate (450) disposed under the display panel, the support plate comprising a pattern (4531) formed at a position corresponding to the folding area, and
at least one functional layer (460) disposed under the support plate;
a first adhesive member (510) disposed between the first housing (110) and the at least one functional layer (460) at a position at least adjacent to one side of the folding area, the first adhesive member having a length in a direction parallel to the folding axis; and
a second adhesive member (520) disposed between the second housing (120) and the at least one functional layer (460) at a position at least adjacent to another side of the folding area, the second adhesive member having a length in a direction parallel to the folding axis.

2. The electronic device of claim 1, wherein the first adhesive member (150) is attached to the first housing and the functional layer, and
wherein the second adhesive member (250) is attached to the second housing and the functional layer.

3. The electronic device of claim 1 or 2, wherein the functional layer comprises:
a first reinforcement plate (4261) corresponding to at least a portion of the first housing, and
a second reinforcement plate (4622) spaced apart from the first reinforcement plate and corresponding to at least a portion of the second housing.

4. The electronic device of claim 1 or 2, wherein the functional layer comprises:
a first digitizer (4611) corresponding to at least a portion of the first housing; and
a second digitizer (4622) electrically connected to the first digitizer and corresponding to at least a portion of the second housing.

5. The electronic device of claim 1 or 2, wherein the pattern (4531) comprises a plurality of openings and/or a plurality of recesses formed in an area corresponding to the folding area.

6. The electronic device of one of claims 1 to 5, wherein the first adhesive member (510) and/or the second adhesive member (520) comprises at least one of double-sided tape, waterproof tape, an optical clear adhesive (OCA), a pressure-sensitive adhesive (PSA), a thermally reactive adhesive, or a general adhesive.

7. The electronic device of claim 1 or 2, further comprising:
a first cushion member (550) disposed between the first housing and the at least one functional layer at a position overlapping at least the folding area when viewed from above the flexible display; and
a second cushion member (560) disposed between the second housing and the at least one functional layer at a position overlapping at least the folding area when viewed from above the flexible display.

8. The electronic device of claim 7, wherein the first cushion member (550) and the second cushion member (560) are made of a material having a higher compression force deflection (CFD) property than one or more peripheral members (463, 464) disposed on a same layer.

9. The electronic device of claim 8, wherein the first cushion member (550) and the second cushion member (560) are made of a material having the CFD property of at least 0.25.

10. The electronic device of claim 8 or 9, wherein the first cushion member (550) and the second cushion member (560) are attached to the first housing (110) and the second housing (120), respectively, excluding the functional layer.

11. The electronic device of claim 8 or 9, wherein the one or more peripheral members (463, 464) comprise at least one of a buffer member, a heat dissipation member, or a waterproof member.

12. The electronic device of claim 8 or 9, wherein the first cushion member (550) and the second cushion member (560) have a thickness equal to or smaller than that of the one or more peripheral members.

13. The electronic device of claim 1, wherein the window layer (410) comprises:
a first layer (411) made of a polymer material; and
a second layer (412) disposed under the first layer and formed of a glass material, and
wherein an adhesive attaching the second layer to the display panel has a thickness (t2) greater than a thickness (t1) of an adhesive attaching the second layer to the first layer.

14. An electronic device comprising:
a first housing (210);
a second housing (220) coupled to the first housing (210) to be foldable around a folding axis (F) via a hinge device (320);
a flexible display (230) disposed to be supported by the first housing (110) and the second housing (120), the flexible display comprising a folding area (230c), the flexible display comprising
a window layer (610),
a display panel (630) disposed under the window layer,
a support plate (650) disposed under the display panel, the support plate comprising a pattern (6531) formed at a position at least corresponding to the folding area, and
at least one functional layer (660) disposed under the support plate (650);
a first cushion member (550) disposed between the first housing (210) and the at least one functional layer (660) at a position overlapping at least the folding area (230c) when viewed from above the flexible display (230); and
a second cushion member (560) disposed between the second housing (220) and the at least one functional layer (660) at a position overlapping at least the folding area (230c) when viewed from above the flexible display (230).

15. The electronic device of claim 14, wherein the first cushion member (550) and the second cushion member (560) are disposed to have a length in a direction parallel to the folding axis (F).
